# EUROPEAN PATENT SPECIFICATION

(11) **EP 4 238 686 B1**
(45) Date of publication and mention of the grant of the patent: **02.12.2026**
(21) Application number: 21885840.5
(22) Date of filing: 06.10.2021
(51) Int. Cl.: B23K 26/067, B23K 26/06, B23K 26/38, B23K 26/364, B23K 26/0622, B23K 101/40, B23K 103/00

(54) **LASER PROCESSING DEVICE AND LASER PROCESSING METHOD**
LASERBEARBEITUNGSVORRICHTUNG UND LASERBEARBEITUNGSVERFAHREN
DISPOSITIF ET PROCÉDÉ DE TRAITEMENT AU LASER

(30) Priority: 28.10.2020 JP 2020180345
(43) Date of publication of application: 06.09.2023
(73) Proprietor: Tokyo Seimitsu Co., Ltd., Hachioji-shi, Tokyo 192-8515 (JP)
(72) Inventor: AIKAWA, Chikara, Hachioji-shi, Tokyo 192-8515 (JP); HAYASHI, Hirokazu, Hachioji-shi, Tokyo 192-8515 (JP)
(74) Representative: Grünecker Patent- und Rechtsanwälte PartG mbB
(86) International application number: PCT/JP2021/036929
(87) International publication number: WO 2022/091721

(56) References cited:
- WO-A1-2015/137179
- JP-A- 2010 207 879
- JP-A- 2013 180 295
- JP-A- 2015 154 009
- JP-A- 2015 167 969
- JP-A- 2017 177 194
- US-A1- 2016 315 010

## Description

### {Technical Field}

The presently disclosed subject matter relates to a laser machining apparatus and a laser machining method for performing laser machining of wafers.

### {Background Art}

**In** the field of manufacturing semiconductor devices in recent years, wafers (semiconductor wafers) are known in which a laminated body, fabricated by laminating a low-permittivity insulator film (Low-k film) made of a glassy material and a functional film configured to form a circuit on a surface of a substrate such as silicon, forms a plurality of devices. **In** such wafers, a plurality of devices are partitioned in a grid pattern by grid of streets, so that individual devices are manufactured by dividing the wafer along the streets.

Known examples of the method of dividing the wafer into a plurality of devices (chips) include a method of using a blade configured to rotate at a high speed, and a method of forming laser machining regions along the streets in the interior of the wafer and exerting an external force along the streets that have reduced strength due to the formation of the laser machining regions. However, in the case of the wafer to which the Low-k film is applied, it is difficult to cut an insulating film and the substrate simultaneously with the blade by the former method because the material of the Low-k film is different from the material of the wafer. **In** the later method, division into the individual devices in good quality is difficult when the Low-k film is present on the streets.

Accordingly, **PTL** 1 discloses a laser machining apparatus configured to perform edge cutting for forming two edge cutting grooves (cutoff grooves) along the streets on the wafer and hollowing for forming a hollow groove (division groove) between the two edge cutting grooves. The laser machining apparatus of this type is configured to retract the Low-k film by forming both the two edge cutting grooves and the hollow groove simultaneously (parallel formation) along the same street with a laser optical system while moving the laser optical system relative to the wafer toward one direction side (for example, a forward path direction side) of the machining feed direction.

**PTL** 2 discloses a laser machining apparatus configured to form a pair of trenches (two first grooves) parallel to each other along a dicing street and a furrow (second groove), which is a recess formed between the pair of trenches with the laser optical system while moving a chuck that holds the wafer and the laser optical system relative to each other. The laser optical system of PTL 2 precedes the laser beam for the machining of the trenches to the laser beam for the machining of the furrow irrespective of the machining feed direction (a forward path direction or a returning path direction) of the laser optical system with respect to the wafer.

In addition, the laser machining apparatus described in PTL 2 performs machining of the furrows by branching the laser beam for the machining of the furrow into four beams of light in the machining feed direction, and focusing the laser beam branched into four beams of light individually on the streets by a shared condenser lens.

### {Citation List}

### {Patent Literature}

{PTL 1} Japanese Patent Application Laid-Open No. 2009-182019
{PTL 2} Japanese Patent Application Laid-Open No. 2016-208035

JP 2010 207879 A relates to a laser beam machining method and a laser beam machining apparatus.

### {Summary of Invention}

### {Technical Problem}

Incidentally, in the laser machining apparatus described in PTL 1, when increasing a machining depth of machined grooves (two edge cutting grooves and a hollow groove) formed on the street, especially the machining depth of the hollow groove, is desired, it is necessary to increase the power of the laser light (pulsed laser light) corresponding to the hollowing or increase the repetition frequency of the laser light. However, in this case, the desired machining depth cannot be obtained, and the machining quality deteriorates because of the dominant backfilling of the machined grooves due to the melting of the wafer.

To prevent deterioration of the machining quality of the machined grooves (hollow grooves), there is a method, for example, of performing hollowing with laser light of power that does not exceed a threshold value of laser light power based on the threshold value at which the machining quality is maintained, the threshold value being determined for each wafer. However, in this case, a plurality of times (a plurality of passes) of hollowing must be performed for each street, which increases the tact time.

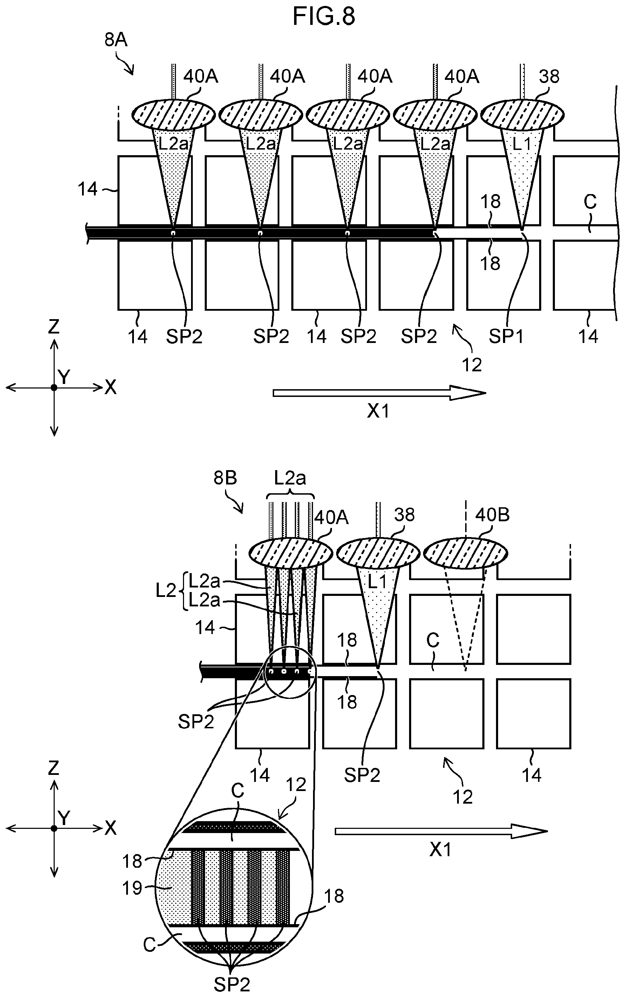

Therefore, when performing the hollowing with laser light of power less than the above-mentioned threshold value, a method of forming hollow grooves of the desired depth by performing hollowing only once per street, for example, by increasing the number of condenser lenses for performing hollowing (see Figure 8 described later). However, in this case, the amount of relative movement (machining distance) of the laser optical system with respect to the wafer increases by an amount corresponding to the increase in the number of condenser lenses, which increases the tact time. In addition, the respective condenser lenses must be aligned in the same line, which increases the complexity and difficulty of the alignment adjustment.

Therefore, as described in PTL 2 described above, a method of branching the laser light corresponding to the hollowing into a plurality of beams of branch light and focus respective beams of branch light onto the streets with a shared condenser lens is conceivable. However, when the branch distance (spacing) of each beam of branch light is narrow, a situation may occur that is similar to a case in which the repetition frequency of the laser light is increased. In this case, the streets are irradiated with laser light (pulsed laser light) one after another on while the wafer is not sufficiently cooled, and thus there is concern that the machining quality of the machined grooves may deteriorate due to increased heat input to the wafers.

In view of such circumstances, it is an object of the presently disclosed subject matter is to provide a laser machining apparatus and a laser machining method that can maintain the machining quality of machined grooves and can prevent an increase in the tact time.

### {Solution to Problem}

A laser machining apparatus according to the present invention is defined in claim 1.

The laser machining apparatus may prevent increase of the tact time and achieves the desired machining depth without deteriorating the machining quality of the machined groove (second groove).

**In** the laser machining apparatus according to another aspect of the presently disclosed subject matter, the laser light emitting system includes a first laser light source configured to emit laser light on the conditions corresponding to the edge cutting, a second laser light source configured to emit laser light on the conditions corresponding to the hollowing, a first light forming element configured to form two beams of first laser light from the laser light emitted from the first laser light source, and a second light forming element configured to form a second laser light from the laser light emitted from the second laser light source, wherein the branching element is provided on an optical path between the second light forming element and the second condenser lens. This allows achievement of speeding-up of laser machining and reduction of the tact time.

**In** the laser machining apparatus according to another aspect of the presently disclosed subject matter, the laser light emitting system includes a laser light source configured to emit laser light; a bifurcating element configured to bifurcate the laser light emitted from the laser light source; a first light forming element configured to form the two beams of first laser light from one of the laser light bifurcated by the bifurcating element; and a second light forming element configured to form the second laser light from the other of the laser light bifurcated by the bifurcating element, wherein the branching element is provided on the optical path between the second light forming element and the second condenser lens.

**In** the laser machining apparatus according to another aspect of the presently disclosed subject matter, the second light forming element forms the second laser light that forms the spot of a non-circular shape on the street, and the laser machining apparatus further includes a second light forming element rotating mechanism configured to rotate the second light forming element in a direction around an axis centered on an optical axis of the second light forming element. This allows for adjustment of the width of the second groove.

The laser machining apparatus according to another aspect of the presently disclosed subject matter includes a first light forming element rotating mechanism configured to rotate the first light forming element in a direction around an axis centered on an optical axis of the first light forming element. This allows for adjustment of the spacing between the two first grooves.

In the laser machining apparatus according to another aspect of the presently disclosed subject matter, the second condenser lens includes two lenses that are arranged with the first condenser lens interposed therebetween and are arranged in a row along the machining feed direction together with the first condenser lens, the laser machining apparatus further includes a connecting optical system configured to guide the two beams of first laser light emitted from the laser light emitting system to the first condenser lens and selectively guide a plurality of beams of the branch light branched by a branching element to the two lenses of the second condenser lens, and the connecting optical system guides a plurality of beams of the branch light to the second condenser lens positioned on the returning path direction side with respect to the first condenser lens, which is opposite from the forward path direction side, when the laser optical system is moved toward the forward path direction side of the machining feed direction relative to the table, and guides a plurality of beams of the branch light to the second condenser lens positioned on the forward path direction side with respect to the first condenser lens when the laser optical system is moved toward the returning path direction side relative to the table. This allows for reduction of the tact time of the laser machining.

In the laser machining apparatus according to another aspect of the presently disclosed subject matter, the second laser light is a pulsed laser light, and at least one of the machining speed and the repetition frequency of the second laser light is adjusted to make the overlap rate in the machining feed direction of the next spot to be irradiated to the spot be 50% or less for each spot. This allows for further improvement of the machining quality of the machined groove (second groove).

A laser machining method according to the present invention is defined in claim 8.

### {Advantageous Effects of Invention}

The presently disclosed subject matter can achieve both maintenance of the machining quality of machined grooves and prevention of the increase of tact time.

### {Brief Description of Drawings}

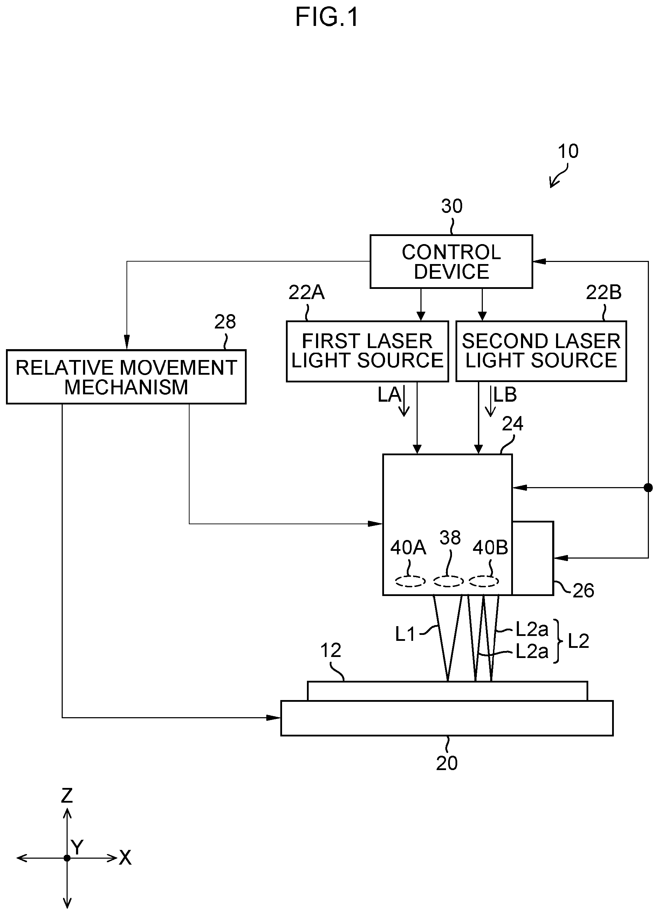

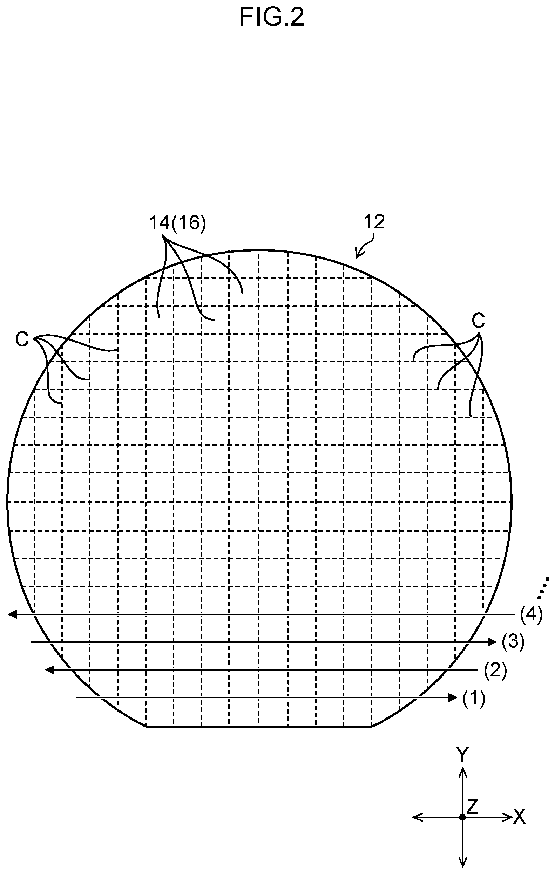

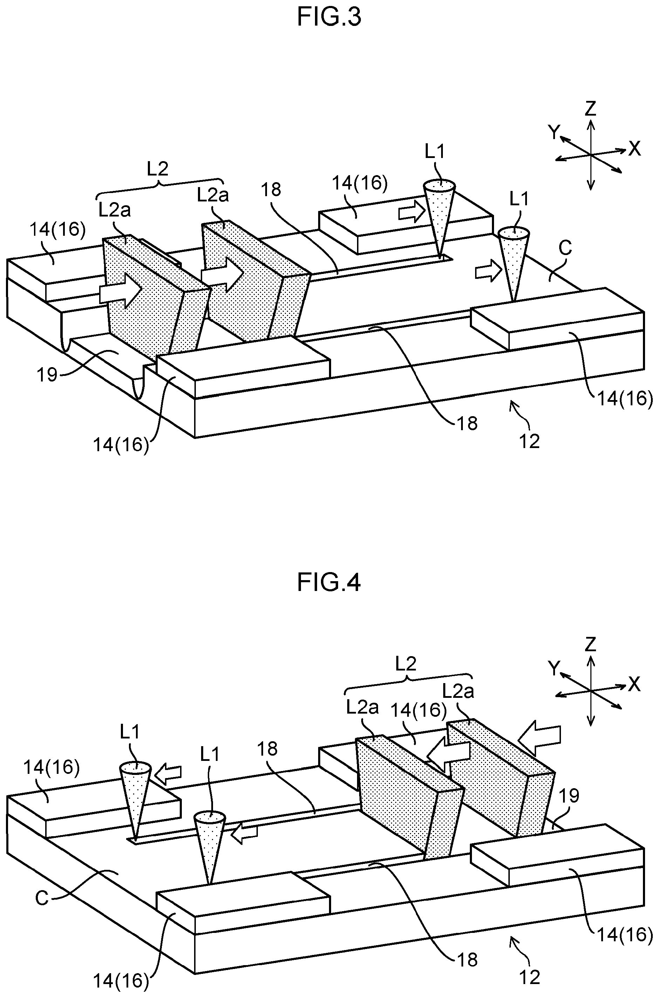

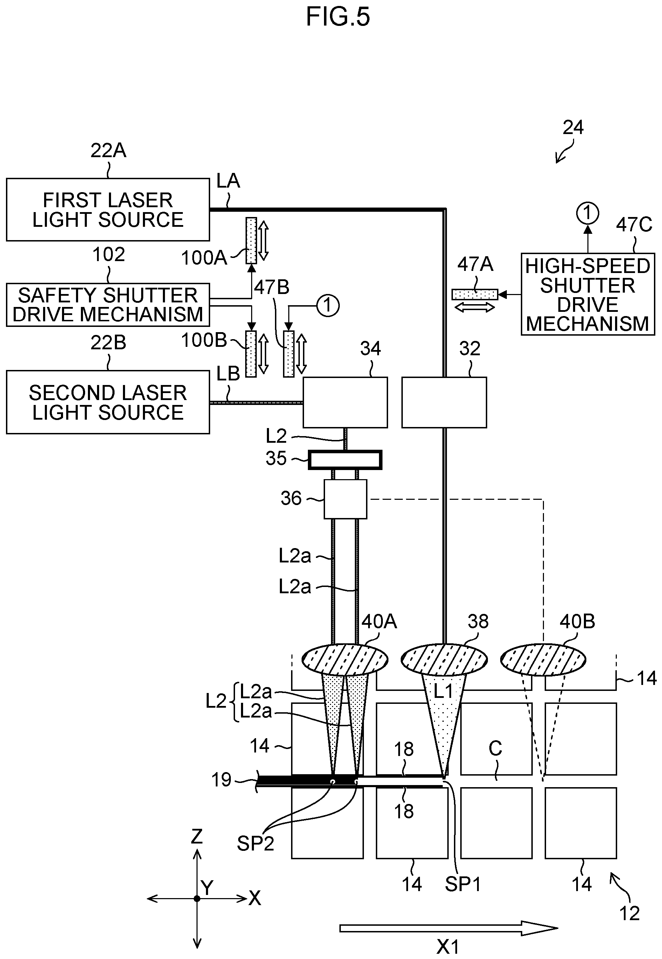

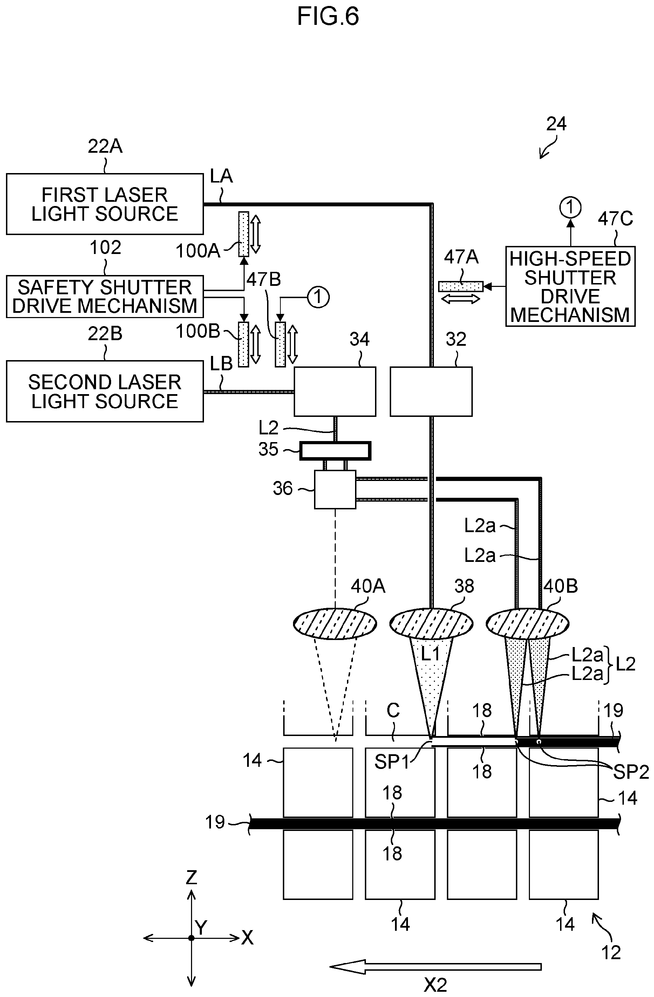

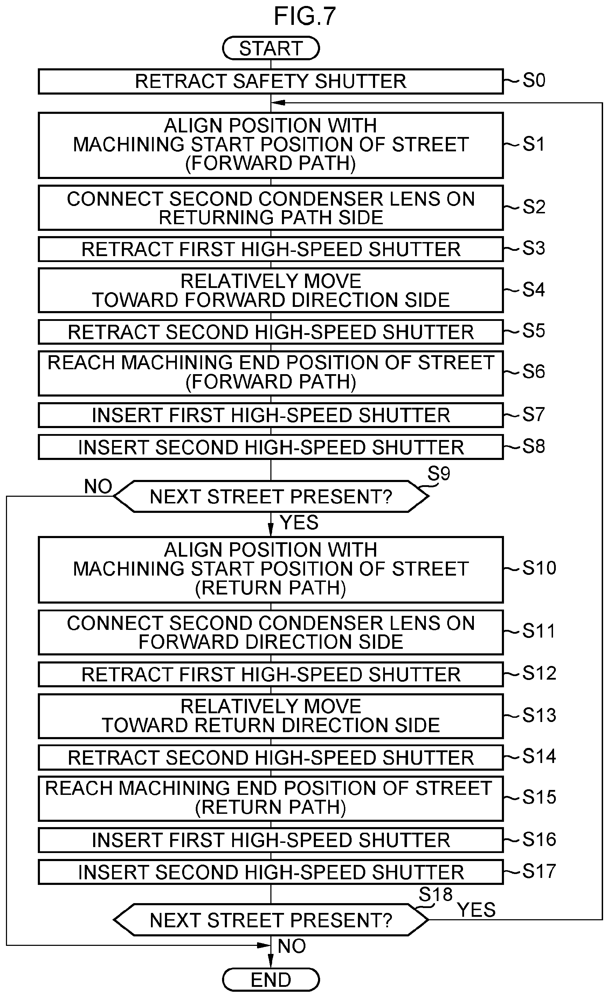

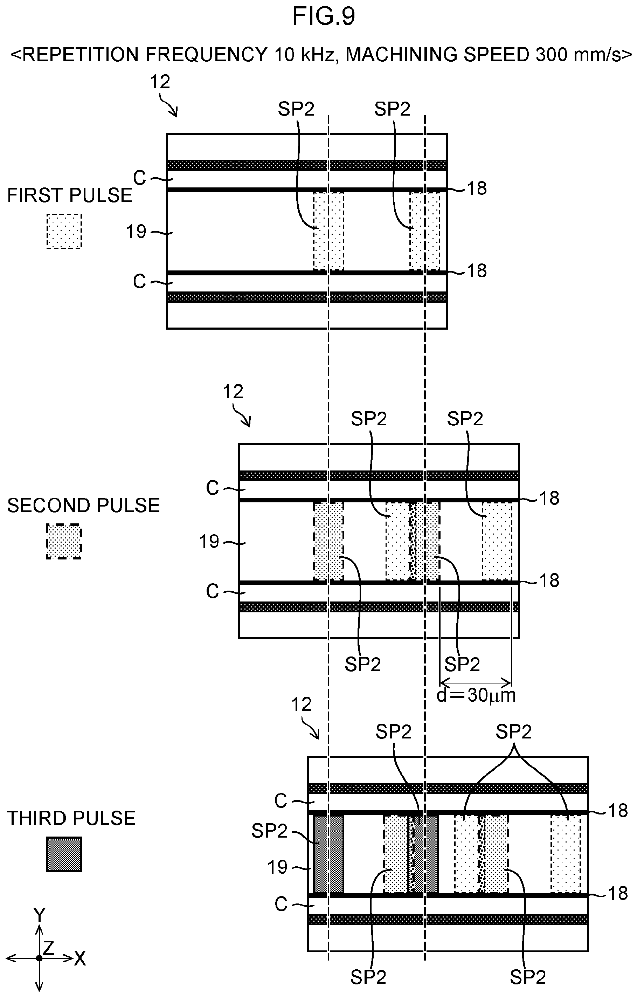

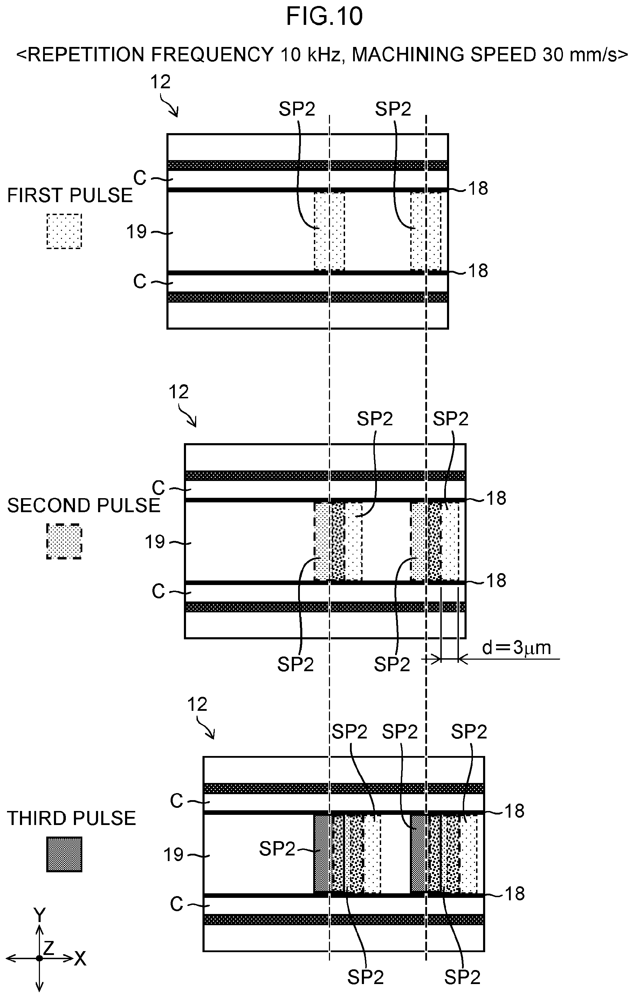

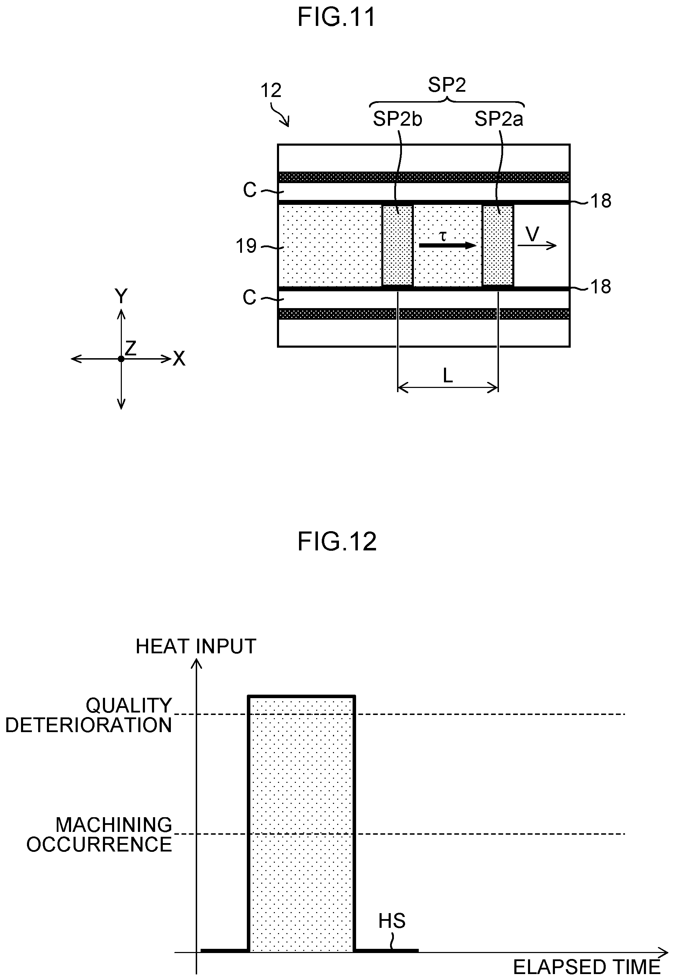

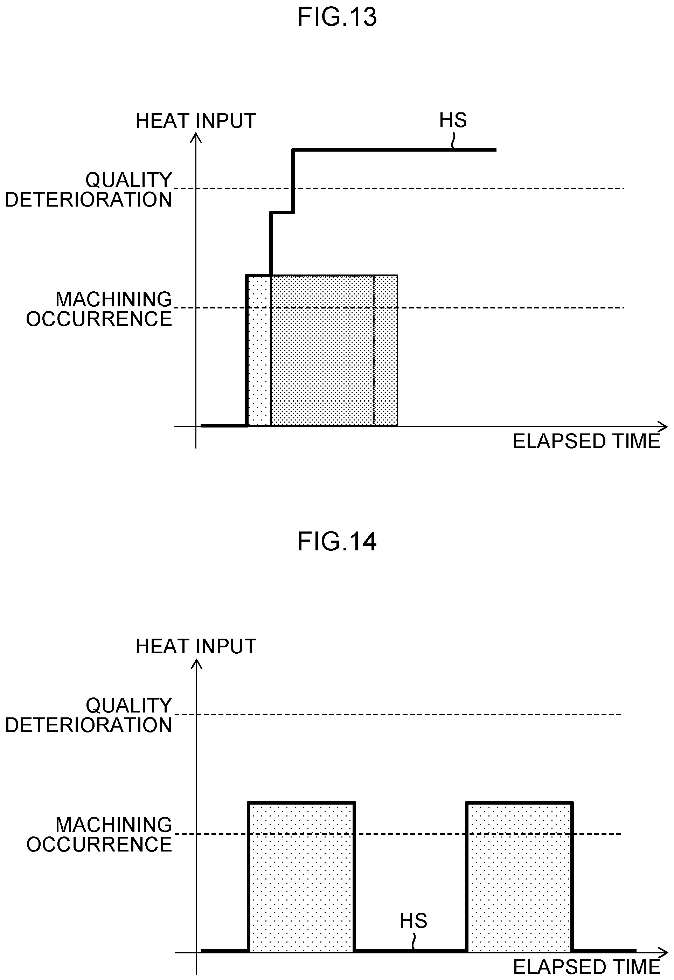

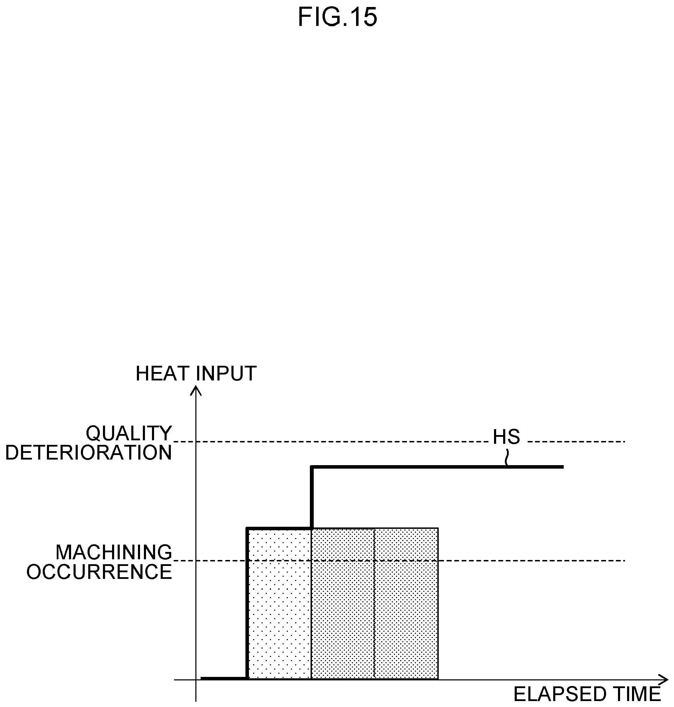

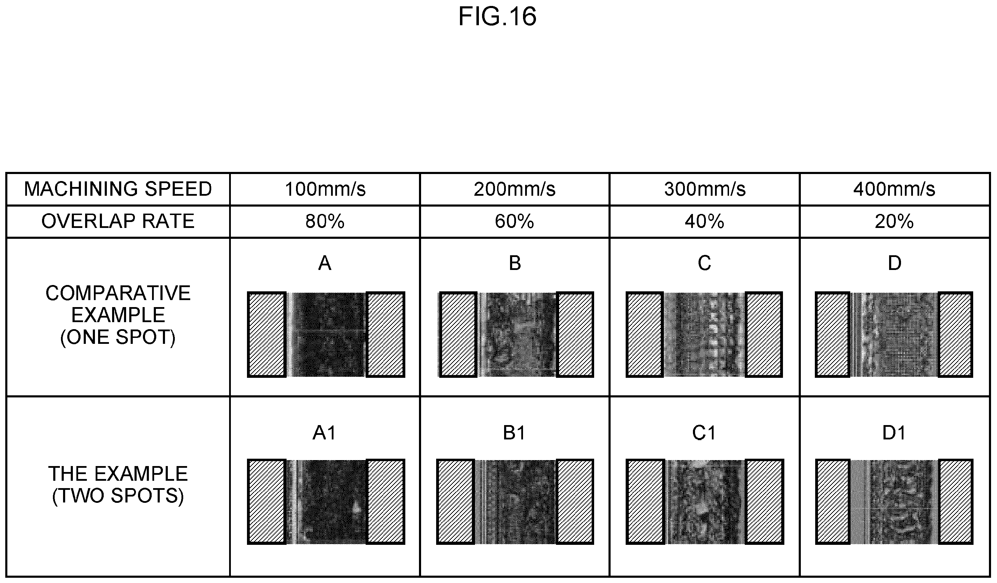

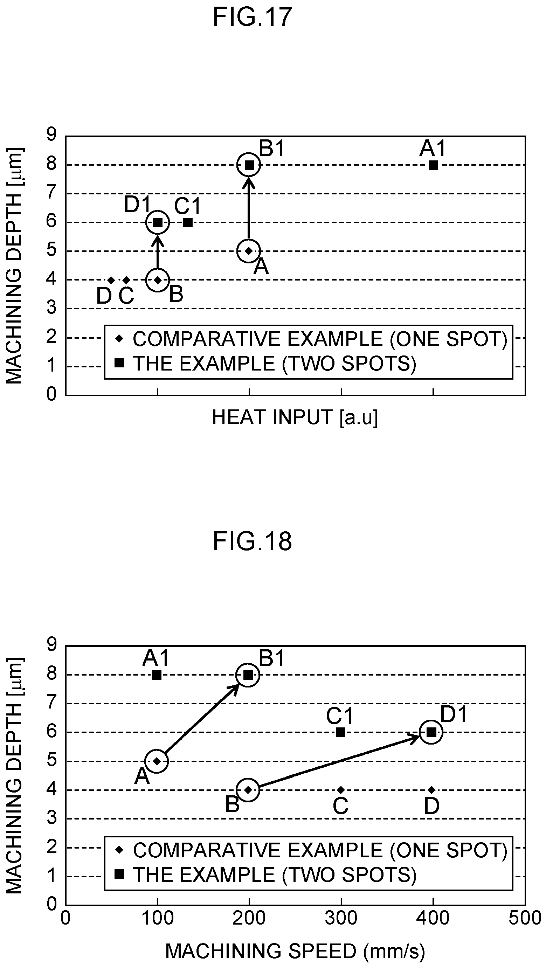

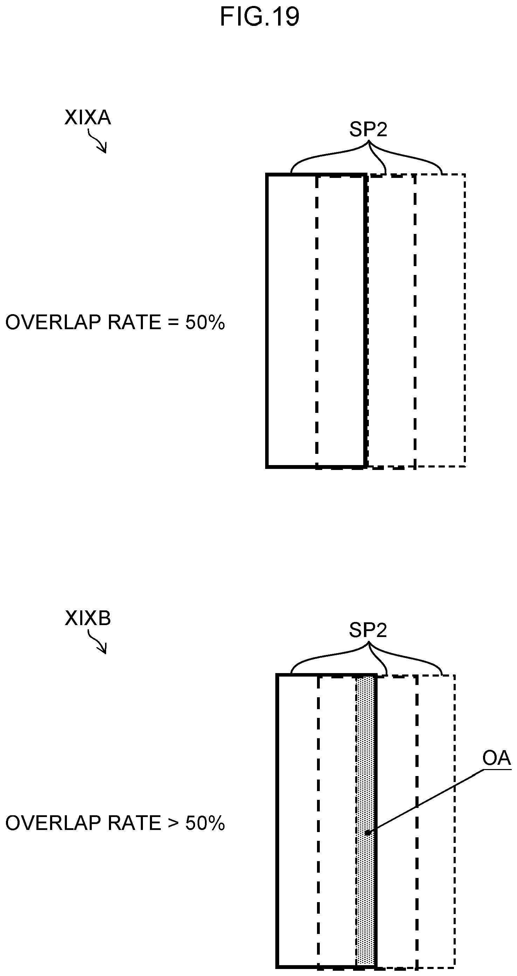

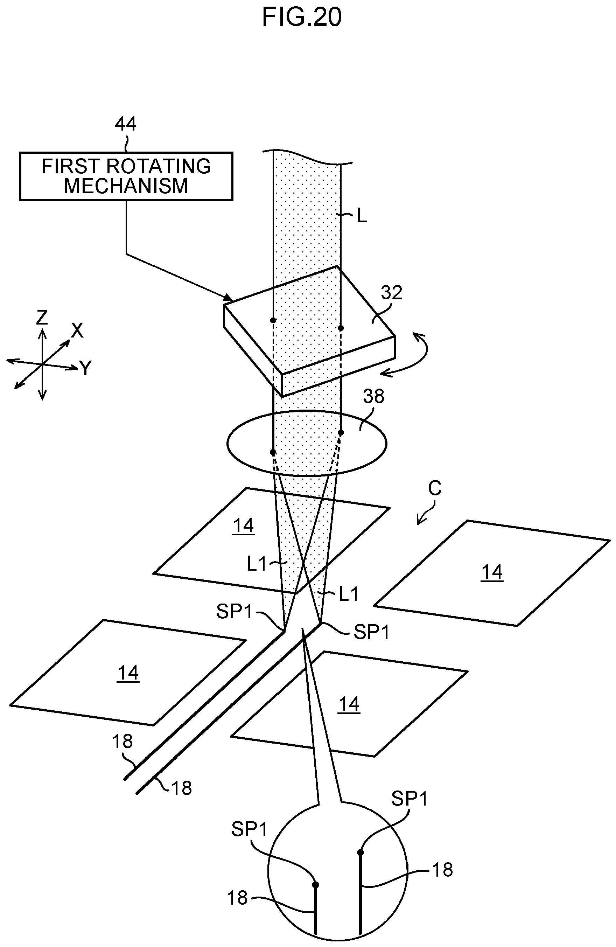

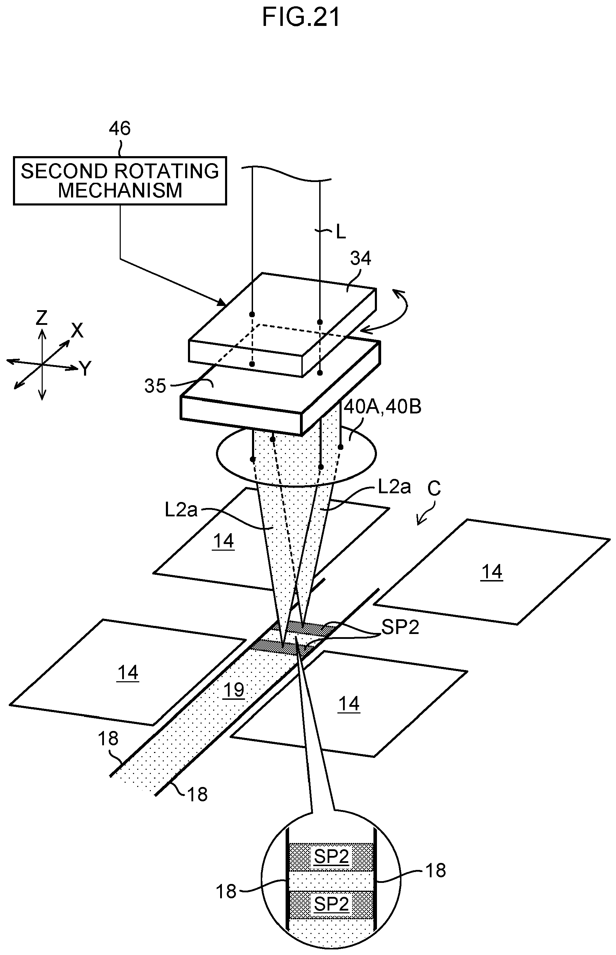

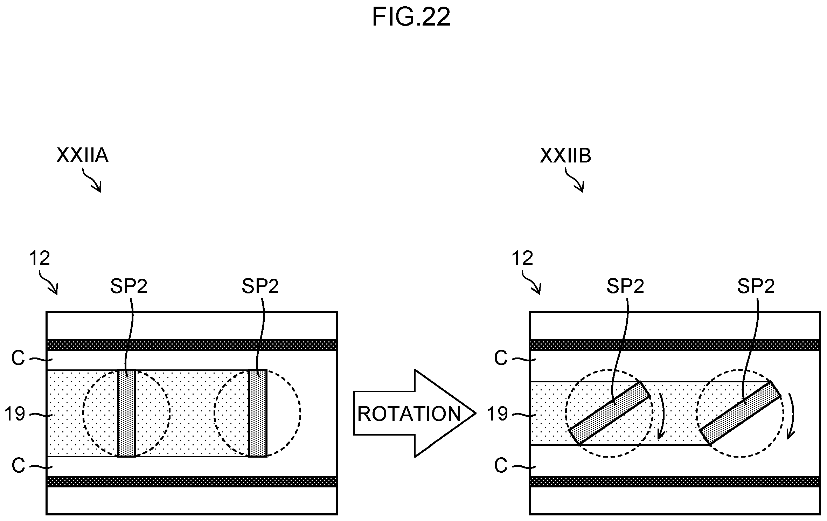

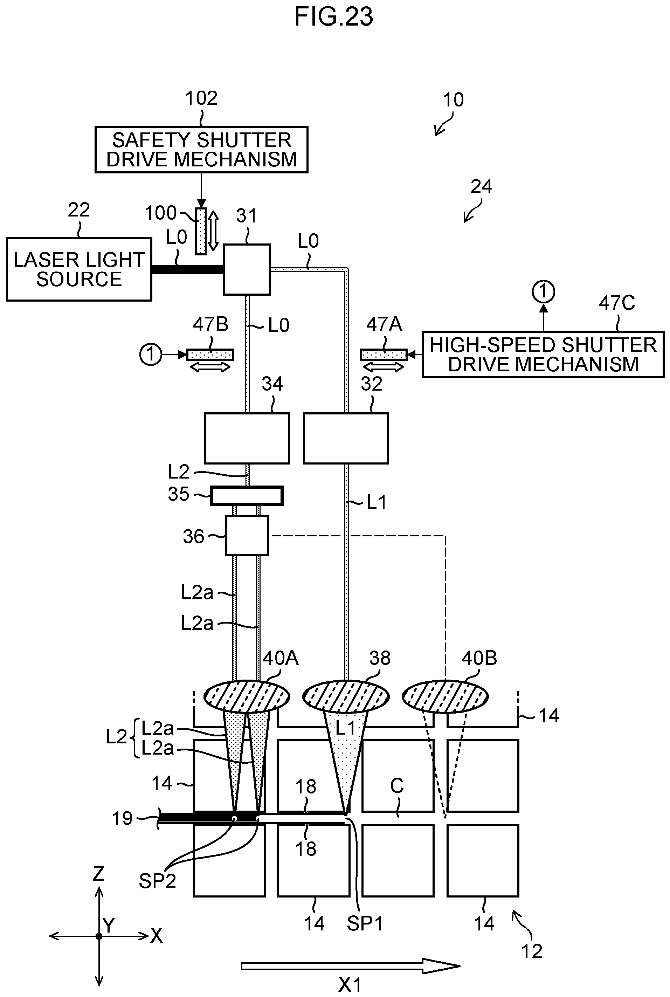

{Figure 1} Figure 1 is a schematic view of a laser machining apparatus according to a first embodiment.
{Figure 2} Figure 2 is a plan view of a wafer to be machined by the laser machining apparatus.
{Figure 3} Figure 3 is an explanatory drawing for explaining laser machining along an odd-numbered streets.
{Figure 4} Figure 4 is an explanatory drawing for explaining the laser machining along even-numbered streets.
{Figure 5} Figure 5 is an explanatory drawing for explaining edge cutting and hollowing with a laser optical system that is moved toward a forward path direction side relative to the wafer.
{Figure 6} Figure 6 is an explanatory drawing for explaining the edge cutting and the hollowing with the laser optical system that is moved toward a returning path direction side relative to the wafer.
{Figure 7} Figure 7 is a flowchart illustrating a flow of laser machining for each street of a wafer with the laser machining apparatus, especially illustrating the operation of a first high-speed shutter, a second high-speed shutter, a first safety shutter, and a second safety shutter, according to the first embodiment.
{Figure 8} Figure 8 is an explanatory drawing for comparing a machining distance required for laser machining for each street in the comparative example and in this embodiment.
{Figure 9} Figure 9 is an explanatory drawing for explaining the hollowing when a repetition frequency of the second laser light is 10 kHz, and the machining speed is 300 mm/s.
{Figure 10} Figure 10 is an explanatory drawing for explaining the hollowing when a repetition frequency of the second laser light is 10 kHz, and the machining speed is 30 mm/s. {Figure 11} Figure 11 is a top view illustrating spots of the respective beams of branch light to be focused on the streets (forward path, returning path) by the second condenser lens.
{Figure 12} Figure 12 is a graph illustrating the relationship between a heat input and an elapsed time at any one point on the street when the second laser light is not branched.
{Figure 13} Figure 13 is a graph illustrating the relationship between the heat input and the elapsed time at any one point on the street when "τ < τ1".
{Figure 14} Figure 14 is a graph illustrating the relationship between the heat input and the elapsed time at any one point on the street when "τ >> τ1" is satisfied.
{Figure 15} Figure 15 is a graph illustrating the relationship between the heat input and the elapsed time at any one point on the street when "τ > τ1" is satisfied.
{Figure 16} Figure 16 is an explanatory drawing illustrating the relationship between the machining conditions of the hollowing and the machining states of a bottom of the hollow groove in "one-spot" in the comparative example and "two-spot" in the example.
{Figure 17} Figure 17 is a graph illustrating the relationship between heat input and the machining depth of the hollow groove for each of the machining conditions (A-D, A1-D1) illustrated in Figure 16.
{Figure 18} Figure 18 is a graph illustrating the relationship between a machining speed and the machining depth of the hollow groove for each of the machining conditions illustrated in Figure 16.
{Figure 19} Figure 19 is an explanatory drawing for explaining a preferred overlap rate for the hollowing.
{Figure 20} Figure 20 is an explanatory drawing for explaining adjustment of spacing between two edge cutting grooves in the Y-direction by the first rotating mechanism.
{Figure 21} Figure 21 is an explanatory drawing for explaining adjustment of width in the Y-direction of the hollow groove by the second rotating mechanism.
{Figure 22} Figure 22 is a top view of spots for each beam of branch light according to a third embodiment.
{Figure 23} Figure 23 is a schematic view of the laser optical system in the laser machining apparatus according to a fourth embodiment.

### {Description of Embodiments}

### [Overall Configuration of Laser Machining Apparatus according to First Embodiment]

Figure 1 is a schematic view of a laser machining apparatus 10 of a first embodiment. As illustrated in Figure 1, the laser machining apparatus 10 performs laser machining (ablation groove machining) on a wafer 12 as a pre-process before dividing the wafer 12 into a plurality of chips 14 (see Figure 2). XYZ-directions in the drawings are orthogonal to each other, of which the X-direction and Y-directions are horizontal, and the Z-direction is vertical. Here, the X-direction corresponds to a machining feed direction of the presently disclosed subject matter.

Figure 2 is a plan view of the wafer 12 to be machined by the laser machining apparatus 10. As illustrated in Figure 2, the wafer 12 is a laminated body including a Low-k film and a functional film forming a circuit laminated on the surface of a substrate such as silicon. The wafer 12 is partitioned into a plurality of regions by a plurality of streets C (lines to be divided) arrayed in a grid pattern. In each of these partitioned regions, there is a device 16 that constitutes the chips 14.

The laser machining apparatus 10 retracts the Low-k film, etc. on the substrate by performing the laser machining on the wafer 12 along the streets C for each street C as illustrated in parenthesized numerals (1) to (4), ... in the drawing.

At this time, the laser machining apparatus 10 alternately switches the direction of movement of a laser optical system 24 (described later) relative to the wafer 12 in the X-direction for each street C in order to reduce the tact time required for the laser machining of the wafer 12.

For example, when performing the laser machining along the odd-numbered streets C indicated by parenthesized numerals (1), (3), etc. in the drawing, the laser optical system 24 described later is moved toward the forward path direction side X1 (see Figure 5) relative to the wafer 12, which is one direction side of the X-direction. When the laser machining is performed along the even-numbered streets C indicated by parenthesized numerals (2), (4), etc. in the drawing, the laser optical system 24 is moved relative to the wafer 12 in the other direction side of the X-direction, that is, in the returning path direction side X2 (see Figure 6) opposite to the forward path direction side X1.

Figure 3 is an explanatory drawing for explaining the laser machining along odd-numbered streets C. Figure 4 is an explanatory drawing for explaining the laser machining along even-numbered streets C.

As illustrated in Figures 3 and 4, edge cutting and hollowing are executed simultaneously (in parallel) as laser machining in this embodiment. The edge cutting is laser machining that uses two beams of first laser light L1 and forms two edge cutting grooves 18 (ablation grooves corresponding to two first grooves of the presently disclosed subject matter) parallel to each other along street C.

The hollowing is laser machining for forming a hollow groove 19 (an ablation groove corresponding to the second groove of the presently disclosed subject matter) between the two edge cutting grooves 18 formed by the edge cutting. In this embodiment, the hollowing is performed using beams of branch light L2a, which are beams formed by branching second laser light L2 having a larger diameter than the two beams of first laser light L1 into a plurality of beams of light in the machining feed direction (X-direction). Details of the two edge cutting grooves 18 and the hollow groove 19, that correspond to ablation grooves, are omitted since they are publicly known technology (see PTL 1).

In the laser machining apparatus 10, the edge cutting is performed prior to the hollowing in both cases where the laser optical system 24 described later is moved relative to the wafer 12 in the forward path direction side X1 (see Figure 5) and in the returning path direction side X2 (see Figure 6).

Returning to Figure 1, the laser machining apparatus 10 includes a table 20, a first laser light source 22A, a second laser light source 22B, the laser optical system 24, a microscope 26, a relative movement mechanism 28, and a control device 30.

The table 20 holds the wafer 12. The table 20 is moved in the X-direction, which is the machining feed direction parallel to the street C to be machined, and the Y-direction, which is parallel to the width direction of the street C, by the relative movement mechanism 28 under the control of the control device 30, and is rotated around a central axis (rotation axis) of the table 20, which is parallel to the Z-direction.

The first laser light source 22A and the second laser light source 22B together with the laser optical system 24 described later constitute the laser optical system of the presently disclosed subject matter. The first laser light source 22A constantly emits laser light LA, which is a pulsed laser light on the conditions suitable for the edge cutting (wavelength, pulse width, and repetition frequency, etc.), to the laser optical system 24. The second laser light source 22B constantly emits laser light LB, which is a pulsed laser light on the conditions suitable for hollowing (wavelength, pulse width, and repetition frequency, etc.), to the laser optical system 24.

Here, it is conceivable to perform both edge cutting grooving and hollowing grooving with the one laser light source 22 (see Figure 23) as in the fourth embodiment described later, but depending on the laser light conditions, the speed of edge cutting grooving can be increased but the speed of hollowing grooving cannot be increased, so that it is necessary to perform the machining at the speed of hollowing grooving, which cannot be improved. The opposite may also be true depending on the laser light conditions. Therefore, the lower speed in each case is the upper speed limit in the laser machining.

Thus, for the edge cutting and the hollowing, there are laser light conditions suitable for machining speed and machining finish, respectively. For this reason, it is preferable to use different light sources (the first laser light source 22A and the second laser light source 22B) for the edge cutting and the hollowing. This allows for faster laser machining, thereby reducing the tact time.

The laser optical system 24 (also referred to as laser unit or laser head) forms the two beams of first laser light L1 for edge cutting based on the laser light LA from the first laser light source 22A, as described later in detail. The laser optical system 24 forms one beam of second laser light L2 for the hollowing based on the laser light LB from the second laser light source 22B, and then branches the second laser light L2 into a plurality of beams of branch light L2a. The laser optical system 24 then emits (irradiates) the two beams of first laser light L1 from the first condenser lens 38 toward the street C. The laser optical system 24 selectively emits (irradiates) each of the beams of branch light L2a from the two second condenser lenses 40A, 40B toward the street C under the control of the control device 30.

Furthermore, the laser optical system 24 is moved in the Y-direction and Z-directions by the relative movement mechanism 28 under the control of the control device 30.

The microscope 26 is fixed to the laser optical system 24 and moves integrally with the laser optical system 24. The microscope 26 takes an image of an alignment reference (illustration is omitted) formed on the wafer 12 prior to the edge cutting and the hollowing. The microscope 26 also takes an image of the two edge cutting grooves 18 and the hollow groove 19 formed along the street C by the edge-cutting and hollowing. The image (image data) taken by the microscope 26 are output to the control device 30, and are displayed on a monitor, not illustrated, by the control device 30.

The relative movement mechanism 28 includes an XYZ actuator, a motor, etc., not illustrated, and performs movement in the XY-direction and rotation around the rotation axis of the table 20, and movement of the laser optical system 24 in the Z-direction under the control of the control device 30. This allows the relative movement mechanism 28 to move the laser optical system 24 relative to the table 20 and wafer 12. The method of relative movement is not limited as long as the laser optical system 24 can be moved relative to the table 20 (wafer 12) in each direction (including rotation).

By driving the relative movement mechanism 28, the alignment of the laser optical system 24 with respect to the machining start position, which corresponds to one end of the street C to be machined, and the relative movement of the laser optical system 24 in the X-direction along the street C [forward path direction side X1 (see Figure 5) or returning path direction side X2 (see Figure 6)] can be performed. By driving the relative movement mechanism 28 to rotate the table 20 by 90°, each of the streets C along the Y-direction of the wafer 12 can be made parallel to the X-direction, which corresponds to the machining feed direction.

The control device 30 includes an arithmetic device such as a personal computer, for example, and is equipped with an arithmetic circuit including various processors (Processors), memory, etc. Various processors include a CPU (Central Processing Unit), a GPU (Graphics Processing Unit), an ASIC (Application Specific Integrated Circuit), and a programmable logic device [for example, an SPLD (Simple Programmable Logic Device), a CPLD (Complex Programmable Logic Device), and FPGAs (Field Programmable Gate Arrays)], etc. The various functions of the control device 30 may be realized by a single processor or by a plurality of processors of the same or different types.

The control device 30 comprehensively controls the operation of the first laser light source 22A, the second laser light source 22B, the laser optical system 24, the microscope 26, and the relative movement mechanism 28, etc.

### [Laser Optical System]

Figure 5 is an explanatory drawing for explaining the edge cutting and the hollowing with the laser optical system 24 that is moved toward the forward path direction side X1 relative to the wafer 12. Figure 6 is an explanatory drawing for explaining the edge cutting and the hollowing with the laser optical system 24 that is moved toward the returning path direction side X2 relative to the wafer 12. Hereafter, relative to the wafer 12, the odd-numbered streets C to be machined with the laser optical system 24 that is moved toward the forward path direction side X1, is referred to as "forward path" and the even-numbered streets C to be machined with the laser optical system 24 that is moved toward the returning path direction side X2 is referred to as "returning path".

As illustrated in Figures 5 and 6, the laser optical system 24 includes a first safety shutter 100A and a second safety shutter 100B, a safety shutter drive mechanism 102, a first light forming element 32, a second light forming element 34, a branching element 35, a connection switching element 36, a first condenser lens 38, two second condenser lenses 40A, 40B, a first high-speed shutter 47A, a second high-speed shutter 47B, and a high-speed shutter drive mechanism 47C.

The first safety shutter 100A is provided as being freely insertable into and retractable from the optical path of the laser light LA between the first laser light source 22A and the first light forming element 32. Likewise, the second safety shutter 100B is provided as being freely insertable into and retractable from the optical path of the laser light LB between the second laser light source 22B and the second light forming element 34.

The safety shutter drive mechanism 102 is an actuator configured to insert and retract the first safety shutter 100A into and from the optical path of the laser light LA and the second safety shutter 100B into and from the optical path of the laser light LB under the control of the control device 30. The safety shutter drive mechanism 102 opens the optical paths of the laser lights LA and LB by inserting the first safety shutter 100A into the optical path of the laser light LA and inserting the second safety shutter 100B into the optical path of the laser light LB except during the laser machining.

On the contrary, the safety shutter drive mechanism 102 opens the optical paths of the laser lights LA and LB by retracting the first safety shutter 100A from the optical path of the laser light LA and retracting the second safety shutter 100B from the optical paths of the laser lights LB during the laser machining.

The first light forming element 32 and the second light forming element 34, together with the previously mentioned first laser light source 22A and the second laser light source 22B, are included in the laser light emitting system of the presently disclosed subject matter. As the first light forming element 32, for example, a Diffractive Optical Element (DOE) is used. The first light forming element 32 forms the two beams of first laser light L1 for the edge cutting from the laser light LA incident from the first laser light source 22A and emits the two beams of first laser light L1 toward the first condenser lens 38. Accordingly, the two beams of first laser light L1 are focused on the street C (forward path and returning path) by the first condenser lens 38 to form two spots SP1 (also referred to as focusing points or machining points) separated in the Y-direction on the street C. Although illustration is omitted, the optical path of the two beams of first laser light L1 from the first light forming element 32 to the first condenser lens 38 (including various optical elements provided on the optical path) constitutes part of the connecting optical system of the presently disclosed subject matter.

As the second light forming element 34, for example, a diffractive optical element and a mask, etc. are used. The second light forming element 34 forms the second laser light L2 for the hollowing from the laser light LB incident from the second laser light source 22B. The second laser light L2 passes through the branching element 35 (described later) to form a plurality of spots SP2 in a rectangular shape (other shapes such as circular shape are also applicable) and along the X-direction between the two edge cutting grooves 18. The width of the spots SP2 in the Y-direction is adjusted to match the spacing between the two edge cutting grooves 18. The second light forming element 34 then emits the second laser light L2 to the branching element 35.

The branching element 35 branches the second laser light L2 incident from the second light forming element 34 into a plurality of beams of branch light L2a along the X-direction (machining feed direction). For example, a diffractive optical element, a refractive optical element, a prism, and a combination thereof are used as the branching element 35. Although the second laser light L2 is bifurcated by the branching element 35 in the drawing, it may be branched into three or more beams of light. The branching element 35 then emits each of the beams of branch light L2a to the connection switching element 36. The specific branching conditions for each of the beams of branch light L2a will be described later.

The connection switching element 36 constitutes the connecting optical system of the presently disclosed subject matter. For example, a known optical switch or various optical elements (a λ/2 plate, a polarizing beam splitter, a half mirror, and a mirror, etc., or a combination thereof) are used as the connection switching element 36. The connection switching element 36 selectively guides each of the beams of branch light L2a emitted from the branching element 35 to the second condenser lenses 40A, 40B under the control of the control device 30.

The first condenser lens 38 and the second condenser lenses 40A, 40B are arranged in a row along the X-direction (machining feed direction). The first condenser lens 38 is positioned between the second condenser lens 40A and the second condenser lens 40B. In other words, the second condenser lenses 40A, 40B are positioned to sandwich the first condenser lens 38 therebetween. The second condenser lens 40A is positioned on the returning path direction side X2 relative to the first condenser lens 38. The second condenser lens 40B is positioned on the forward path direction side X1 relative to the first condenser lens 38.

The first condenser lens 38 focuses the two beams of first laser light L1 incident from the first light forming element 32 onto the street C (forward path and returning path). The second condenser lens 40A focuses each of the beams of branch light L2a incident from the connection switching element 36 onto the street C (forward path). The second condenser lens 40B focuses each of the beams of branch light L2a incident from the connection switching element 36 onto the street C (returning path).

When the laser optical system 24 is moved toward one of the forward path direction side X1 and the returning path direction side X2 relative to the wafer 12 by the relative movement mechanism 28, the connection switching element 36 guides each of the beams of branch light L2a to the lens, which is one of the second condenser lenses 40A, 40B positioned on the other one of the forward path direction side X1 and the returning path direction side X2, with respect to the first condenser lens 38.

Specifically, as illustrated in Figure 5, the connection switching element 36 guides each of the beams of branch light L2a emitted from the branching element 35 to the second condenser lens 40A when the laser optical system 24 is moved toward the forward path direction side X1 relative to the wafer 12 by the relative movement mechanism 28. Accordingly, each of the beams of branch light L2a is individually focused by the second condenser lens 40A on the street C (forward path) to form a spot SP2 for each of the beams of branch light L2a. As a result, the two edge cutting grooves 18 are formed by executing edge cutting first and then the hollow groove 19 is formed between the two edge cutting grooves 18 by executing the hollowing along the street C (forward path) by the relative movement of the laser optical system 24 toward the forward path direction side X1.

As illustrated in Figure 6, the connection switching element 36 guides each of the beams of branch light L2a emitted from the branching element 35 to the second condenser lens 40B when the laser optical system 24 is moved toward the returning path direction side X2 relative to the wafer 12 by the relative movement mechanism 28. Accordingly, each of the beams of branch light L2a is individually focused by the second condenser lens 40B on the street C (returning path) to form a spot SP2 for each of the beams of branch light L2a. As a result, the two edge cutting grooves 18 are formed by executing edge cutting first and then the hollow groove 19 is formed between the two edge cutting grooves 18 by executing the hollowing along the street C (returning path) by the relative movement of the laser optical system 24 toward the returning path direction side X2.

As described above, in this embodiment, the second laser light L2 is branched into a plurality of beams of branch light L2a, and each of the beams of branch light L2a is individually focused on the street C by the second condenser lenses 40A, 40B, so that each of the beams of branch light L2a can be used to perform the hollowing of the street C. As a result, by a single relative movement of the laser optical system 24 relative to the wafer 12 in the forward path direction side X1 or in the returning path direction side X2, hollowing can be simultaneously performed on the street C by a plurality of times corresponding to the number of beams of branch light L2a. Therefore, the machining depth of the hollow grooves 19 (machined grooves) can be deepened without increasing the power of the second laser light L2. This allows the second laser light L2 to perform the hollowing with a power which can maintain the machining quality of the hollow groove 19 without increasing the tact time.

The first high-speed shutter 47A is provided as being freely insertable into and retractable from the optical path of the laser light LA between the first laser light source 22A and the first light forming element 32 (between the first light forming element 32 and the first condenser lens 38 is also applicable). The first high-speed shutter 47A, when inserted in the optical path between the first laser light source 22A and the first light forming element 32, stops the emission of the two beams of first laser light L1 from the first condenser lens 38 by blocking the laser light LA incident on the first light forming element 32 from the first laser light source 22A.

The second high-speed shutter 47B is provided as being freely insertable into and retractable from the optical path of the laser light LB between the second laser light source 22B and the second light forming element 34 (between the second light forming element 34 and the connection switching element 36 is also applicable). The second high-speed shutter 47B, when inserted in the optical path between the second laser light source 22B and the second light forming element 34, stops the emission of each of the beams of branch light L2a from the second condenser lenses 40A, 40B by blocking the laser light LB incident on the second light forming element 34 from the second laser light source 22B.

The high-speed shutter drive mechanism 47C is an actuator configured to insert and retract the first high-speed shutter 47A and the second high-speed shutter 47B into and from each of the optical path, already described, under the control of the control device 30. The high-speed shutter drive mechanism 47C retracts the first high-speed shutter 47A out of the optical path of the laser light LA during the edge cutting and inserts the first high-speed shutter 47A into the optical path of the laser light LA except during the edge cutting. Likewise, the high-speed shutter drive mechanism 47C retracts the second high-speed shutter 47B out of the optical path of the laser light LB during the hollowing and inserts the second high-speed shutter 47B into the optical path of the laser light LB except during the hollowing.

### [Laser machining (operation of each shutter)]

Figure 7 is a flowchart illustrating a flow of the laser machining for each street C of a wafer 12 by the laser machining apparatus 10, especially illustrating the operation of the first high-speed shutter 47A, the second high-speed shutter 47B, the first safety shutter 100A, and the second safety shutter 100B, according to the first embodiment described above.

As illustrated in Figure 7, when the wafer 12 to be laser-machined is held on the table 20, the control device 30 first drives the safety shutter drive mechanism 102 to retract each safety shutter 100A, 100B from the optical path of laser light LA, LB (step S0).

Subsequently, the control device 30 drives the relative movement mechanism 28 to move the microscope 26 relative to the wafer 12 to a position which allows imaging of alignment reference of the wafer 12 (illustration is omitted), and then causes the microscope 26 to take an image of the alignment reference. The control device 30 then performs alignment detection to detect the position of each street C in the wafer 12 based on the captured image of the alignment reference taken by the microscope 26. Subsequently, the control device 30 drives the relative movement mechanism 28 to position the optical axis of the first condenser lens 38 of the laser optical system 24 with the machining start position of the first street C (forward path) (Step S1).

The control device 30, after having driven the connection switching element 36 to switch the lens to emit each of the beams of branch light L2a to the second condenser lens 40A (step S2), drives the high-speed shutter drive mechanism 47C to retract the first high-speed shutter 47A from the optical path of the laser light LA (step S3). Accordingly, the two beams of first laser light L1 emit from the first condenser lens 38, so that the two beams of first laser light L1 are focused on the machining start position on the street C (forward path).

Subsequently, the control device 30 drives the relative movement mechanism 28 to move the laser optical system 24 toward the forward path direction side X1 relative to the wafer 12 (Step S4). When the optical axis of the second condenser lens 40A reaches the machining start position of the street C (forward path), the control device 30 drives the high-speed shutter drive mechanism 47C to retract the second high-speed shutter 47B from the optical path of the laser light LB (Step S5). Accordingly, each of the beams of branch light L2a is emitted from the second condenser lens 40A, and each of the beams of branch light L2a is focused on the machining start position described above.

When the relative movement of the laser optical system 24 toward the forward path direction side X1 continues, spots SP1 of the two beams of first laser light L1 and the spots SP2 of each of the beams of branch light L2a move toward the forward path direction side X1 along the street C (forward path) as illustrated in Figure 3 and Figure 5. Consequently, formation of the two edge cutting grooves 18 by the edge cutting and formation of the hollow groove 19 by the hollowing are executed simultaneously with spacing along the street C (forward path).

The control device 30 drives the high-speed shutter drive mechanism 47C at a timing when the spots SP1 reaches the machining end position of the street C (forward path) to insert the first high-speed shutter 47A into the optical path of the laser light LA (Steps S6, S7). In addition, the control device 30 drives the high-speed shutter drive mechanism 47C at a timing when each of the spots SP2 reaches the machining end position, described above, to insert the second high-speed shutter 47B into the optical path of the laser light LB (Steps S8). Accordingly, laser machining of the first street C (forward path) is completed.

When the laser machining of the first street C (forward path) is completed, the control device 30 drives the relative movement mechanism 28 to align the positions of the optical axis of the first condenser lens 38 and the machining start position of the second street C (returning path) (Yes in Step S9, Step S10).

The control device 30, after having driven the connection switching element 36 to switch the lens to emit each of the beams of branch light L2a to the second condenser lens 40B (step S11), drives the high-speed shutter drive mechanism 47C to retract the first high-speed shutter 47A from the optical path of the laser light LA (step S12). Accordingly, the two beams of first laser light L1 is focused on the machining start position on the street C (returning path) by the first condenser lens 38.

Subsequently, the control device 30 drives the relative movement mechanism 28 to move the laser optical system 24 toward the returning path direction side X2 relative to the wafer 12 (Step S13). When the optical axis of the second condenser lens 40B reaches the machining start position of the street C (returning path), the control device 30 drives the high-speed shutter drive mechanism 47C to retract the second high-speed shutter 47B from the optical path of the laser light LB (Step S14). Accordingly, each of the beams of branch light L2a is focused by the second condenser lens 40B to the machining start position.

When the relative movement of the laser optical system 24 toward the returning path direction side X2 continues, spots SP1 of the two beams of first laser light L1 and the spots SP2 of each of the beams of branch light L2a move toward the returning path direction side X2 along the street C (returning path) as illustrated in Figure 4 and Figure 6. Consequently, formation of the two edge cutting grooves 18 by the edge cutting and formation of the hollow groove 19 by the hollowing are executed simultaneously with spacing along the street C (returning path).

The control device 30 drives the high-speed shutter drive mechanism 47C at a timing when the spots SP1 reaches the machining end position of the street C (returning path) to insert the first high-speed shutter 47A into the optical path of the laser light LA (Steps S15, S16). In addition, the control device 30 drives the high-speed shutter drive mechanism 47C at a timing when the spots SP2 of each of the beams of branch light L2a reaches the machining end position to insert the second high-speed shutter 47B into the optical path of the laser light LB (Step S17). Accordingly, laser machining of the second street C (returning path) is completed.

In the same manner, the laser machining (edge cutting and hollowing) are repeatedly executed along all the streets C extending in parallel to the X-direction (Yes in Step S9, Yes in Step S18). Subsequently, the control device 30 drives the relative movement mechanism 28 to rotate the table 20 by 90°, and then repeats the series of processes described above. Accordingly, the laser machining is executed along each of the streets C having a grid pattern.

Figure 8 is an explanatory drawing for comparing the machining distance (the amount of relative movement of the laser optical system 24 relative to the wafer 12) required for laser machining for each of the streets C in the comparative example (see reference sign 8A) and in this embodiment (see reference sign 8B). In Figure 8, a case where the second laser light L2 is branched into four beams of light is exemplified.

In this embodiment, the second laser light L2 is branched into each of the beams of branch light L2a within one (shared) second condenser lens 40A (second condenser lens 40B), but a method of increasing the number of the second condenser lenses 40A, 40B that perform the hollowing is also applicable, for example, as in the comparative example illustrated by a reference sign 8A in Figure 8.

However, in the comparative example, the movement of the laser optical system 24 relative to the wafer 12 needs to be continued until the last of the plurality of second condenser lenses 40A, 40B reaches the machining end position, which increases the tact time due to the increased machining distance of laser machining. In particular, when laser machining of street C (forward path, returning path) is done in both ways as in this embodiment, the machining distance is further increased. In addition, the plurality of second condenser lenses 40A, 40B must be placed in the same alignment, which increases the complexity and difficulty of alignment adjustment.

In contrast, as illustrated by a reference sign 8B in Figure 8, in this embodiment, the second laser light L2 (spots SP2) are branched within each one of the (shared) second condenser lenses 40A, 40B, so that the machining distance is not increased and an increase in the tact time is prevented unlike the comparative example. In addition, the alignment adjustment of the plurality of second condenser lenses 40A, 40B as in the comparative example is no longer necessary.

### [Hollowing]

Figure 9 is an explanatory drawing for explaining hollowing when a repetition frequency of the second laser light L2 is 10 kHz, and the machining speed is 300 mm/s. Figure 10 is an explanatory drawing for explaining hollowing when a repetition frequency of the second laser light L2 is 10 kHz, and the machining speed is 30 mm/s.

As illustrated in Figures 9 and 10, by the hollowing, a plurality of the spots SP2 are formed on the street C with the laser optical system 24. In this case, since the second laser light L2 is a pulsed laser light, irradiation of each of the beams of branch light L2a from the laser optical system 24 to the street C is performed intermittently (at regular intervals) according to the repetition frequency of the second laser light L2. At the same time, the relative movement mechanism 28 moves the laser optical system 24 in the X-direction relative to the wafer 12, specifically, moves the wafer 12 in the X-direction at a predetermined machining speed. As a result, the position of each spot SP2 moves along the street C as the street C is irradiated with the pulse of each of the beams of branch light L2a.

A spot displacement d, which is a displacement of the position of each spot SP2, varies with the repetition frequency and machining speed of the second laser light L2.

For example, as illustrated in Figure 9, when the repetition frequency is 10 kHz and the machining speed is 300 mm/s, the spot displacement d is 30 µm. Likewise, as illustrated in Figure 10, when the repetition frequency is 10 kHz and the machining speed is 30 mm/s, the spot displacement d is 3 µm. The spot displacement d decreases as the repetition frequency increases and conversely increases as the repetition frequency decreases.

Figure 11 is an explanatory drawing for explaining the laser machining method of the presently disclosed subject matter, and more specifically, is a top view illustrating the spot SP2 of each of the beams of branch light L2a that is focused on street C by the second condenser lenses 40A, 40B (forward path, returning path).

In this embodiment, as illustrated in Figure 11, "L" designates the spacing between the spots SP2 for each of the beams of branch light L2a that is focused on the street C, that is, the branch distance, which is the spacing between the leading spot SP2a and the trailing spot SP2b adjacent to each other in the spots SP2 for each of the beams of branch light L2a. Note that, among the spots SP2 adjacent to each other, the one moving ahead along street C is the leading spot SP2a and the one moving behind along street C is the trailing spot SP2b.

The time period τ until the trailing spot SP2b overlaps with the machining position of the leading spot SP2a on the street C is expressed by τ = L/V, where "V" is the machining speed of laser machining (edge cutting and hollowing).

If the time period τ is short, that is, if the branch distance L is short or the machining speed V is fast, the condition is the same as if the repetition frequency of the second laser light L2 is increased, and the heat input to the wafer 12 becomes too large, resulting in deterioration of the machining quality of the hollow groove 19. Conversely, if the time period τ is long, that is, if the branch distance L is long or the machining speed V is slow, this machining position is cooled before the trailing spot SP2b overlaps the machining position of the leading spot SP2a on the street C, so that the heat input to the wafer 12 is kept within a certain range. As a result, the machining quality of the hollow groove 19 is maintained.

Therefore, in this embodiment, the hollowing (laser machining) is performed in a state in which τ > τ1 is satisfied, where τ1 is the time threshold, which is the threshold value (upper limit) of the time period τ at which deterioration of the machining quality of the hollow groove 19 may occur. The time threshold τ1 can be determined according to the type of wafer 12, the type and power of the second laser light L2, and other factors in advance by experiment or simulation. The "state in which τ > τ1 is satisfied" is a state in which at least one of the branch distance L and the machining speed V is adjusted to satisfy τ > τ1. Furthermore, if there are three or more beams of branch light L2a, in the same manner, τ > τ1 should be satisfied between the beams of branch light L2a (leading spot SP2a and trailing spot SP2b) that are adjacent to each other.

Figures 12 through 15 are graphs illustrating the relationship between heat input and elapsed time at any one point on street C. Figure 12 illustrates the relationship between the heat input and the elapsed time at the any one point when the second laser light L2 is not branched. Figure 13 illustrates the relationship between the heat input at the any one point and the elapsed time when the second laser light L2 is bifurcated but τ is "τ < τ1". Figure 14 illustrates the relationship between the heat input at the any one point and the elapsed time when the second laser light L2 is bifurcated and τ satisfies "τ >> τ1". Figure 15 illustrates the relationship between the heat input at the any one point and the elapsed time when the second laser light L2 is bifurcated and τ satisfies "τ > τ1".

In Figures 12 through 15, the energy of each pulse of the second laser light L2 and each of the beams of branch light L2a is represented as a rectangle to prevent complications in the explanation, but other shapes, such as Gaussian or triangular waves, are also applicable. In Figures 12 through 15, "Machining Occurrence" indicates the threshold value of heat input that enables the formation of the hollow groove 19, and "Quality Deterioration" indicates the threshold value of heat input at which the machining quality of the hollow groove 19 deteriorates.

As illustrated in Figure 12, when the second laser light L2 is not to be branched, the power of the second laser light L2 needs to be increased to deepen the machining depth of the hollow groove 19. As a result, irradiation of a single pulse of the second laser light L2 to any one point causes the heat storage HS (heat input) at the any one point to exceed the "quality deterioration" threshold value.

As illustrated in Figure 13, when the second laser light L2 is bifurcated but τ is "τ < τ1," that is, when the branch distance L is short or the machining speed V is fast (too high repetition frequency), the heat input by each of the beams of branch light L2a (leading spot SP2a and trailing spot SP2b) accumulates heat input at the any one point. As a result, the heat storage HS (heat input) at the one arbitrary point exceeds the "quality deterioration" threshold value.

As illustrated in Figure 14, when the second laser light L2 is bifurcated and τ satisfies "τ >> τ1," the heat storage HS (heat input) by the leading spot SP2a at the any one point exceeds the threshold value of "machining occurrence" and then is sufficiently cooled before the heat input by the trailing spot SP2b starts. Therefore, even after heat input by the trailing spot SP2b is started to the any one point, the heat storage HS (heat input) does not exceed the threshold value of "quality deterioration" and the machining quality of the hollow groove 19 is maintained. As a result, the desired machining depth is achieved without deteriorating the machining quality of the hollow groove 19.

As illustrated in Figure 15, when the second laser light L2 is bifurcated and τ satisfies "τ > τ1," τ is larger than that in Figure 13 (for example, the branch distance L is wider), the heat storage HS (heat input) does not exceed the threshold value of "quality deterioration" even if the heat input of the leading spot SP2a and trailing spot SP2b at the any one point is continuous, so that the machining quality of the hollow groove 19 is maintained. As a result, the desired machining depth is achieved without deteriorating the machining quality of the hollow groove 19.

### [Effects of First Embodiment]

As described thus far, in the first embodiment, the second laser light L2 (spot SP2) is branched into a plurality of beams of light in the second condenser lenses 40A, 40B, thereby preventing an increase in the tact time. In the first embodiment, by performing the hollowing with at least one of the branch distance L and the machining speed V (repetition frequency) adjusted so that τ > τ1 is satisfied, the desired machining depth is achieved without deteriorating the machining quality of the hollow groove 19. As a result, according to the first embodiment, both of prevention of increase in the tact time and maintenance of the machining quality of the hollow groove 19 having the desired machining depth can be achieved.

### [Second Embodiment]

The laser machining apparatus 10 according to a second embodiment will be described below. As explained in the first embodiment described above, to satisfy τ > τ1, the branch distance L can be wider or the machining speed V can be slower, or both. In this case, the slower the machining speed V is, the higher the overlap rate in the X-direction (machining feed direction) of a next spot SP2 irradiated to the spot SP2 irradiated to street C for each spot SP2. And, as illustrated in Figure 16 described later, there is a correlation between the overlap rate and the machining quality of the hollow groove 19. Therefore, in the second embodiment, at least one of the machining speed V and the repetition frequency of the second laser light L2 is adjusted so that τ > τ1 and the overlap rate further satisfies the predetermined condition (50% or less) described later.

Note that since the laser machining apparatus 10 of the second embodiment has basically the same configuration as the laser machining apparatus 10 of the first embodiment described above, those having the same function and configuration as the first embodiment are designated by the same reference signs and descriptions thereof are omitted.

Figure 16 is an explanatory drawing illustrating the relationship between the machining conditions of the hollowing (machining speed V and overlap rate) and the machining state of the bottom surface of the hollow groove 19 in "one spot" in the comparative example in which the second laser light L2 is not bifurcated and "two spots" in the example in which the second laser light L2 is bifurcated. Figure 17 is a graph illustrating the relationship between heat input and the machining depth of the hollow groove 19 for each of the machining conditions (A-D, A1-D1) illustrated in Figure 16. Figure 18 is a graph illustrating the relationship between a machining speed V and the machining depth of the hollow groove 19 for each of the machining conditions illustrated in Figure 16.

The machining conditions other than the machining speed V and overlap rate are as follows: the repetition frequency is 50 kHz, the width of the second laser light L2 and the branch light L2a in the X-direction (machining feed direction) is 10 µm, and the branch distance L in the example is 100 µm. The energy of the second laser light L2 in the comparative example and that of the individual beams of branch light L2a in the example are identical. Therefore, when comparing the magnitudes of energy to be applied to street C between the example and the comparative example, that in the example is twice that in the comparative example on the same machining conditions (machining speed V and overlap rate).

As illustrated in Figure 16, when the machining qualities of the hollow groove 19 for each machining condition are compared between the present and comparative examples, the machining quality of the hollow groove 19 on the machining conditions C1 and D1 of the example is good because a metallic luster is seen on the surface of the hollow groove 19. The machining quality of the hollow grooves 19 in the example is inferior to that on the machining conditions C1 and D1 described above because the bottom of the hollow grooves 19 is slightly charred on the machining conditions A1 and B1 in the example.

On the other hand, on machining condition A in the comparative example, the bottom surface of the hollow groove 19 is completely charred, so that the machining quality of the hollow groove 19 is evaluated as NG. On the machining conditions B to D in the comparative examples, insufficient machining of the hollow groove 19 may occur, so that the machining quality of the hollow groove 19 is evaluated as NG.

As illustrated in Figures 17 and 18, on the machining conditions D1 in the example and the machining condition B in the comparative example, the heat input per unit area to the street C is the same, but the machining depth of the hollow groove 19 can be made deeper on the machining condition D1. Furthermore, the machining quality of the hollow groove 19 is better on the machining condition D1 than on the machining condition B, as previously explained in Figure 16. The same applies to the machining condition B1 in the example and the machining condition A in the comparative example.

As illustrated in Figures 16 through 18, a comparison of the machining conditions A1 through D1 in the example illustrates that a decrease in the machining quality of the hollow groove 19 occurs when the overlap rate is higher than 50%.

Figure 19 is an explanatory drawing for explaining a preferred overlap rate for the hollowing (laser machining). As designated by reference characters XIXA and XIXB in Figure 19, when the overlap rate of spot SP2 is larger than 50%, a region OA is generated on street C, where the branch light L2a for three spots is irradiated. As a result, as illustrated in Figure 13 described above, there is a risk that the machining quality of the hollow groove 19 may deteriorate due to an increase in heat storage HS (heat input) or that the heat storage HS may exceed the "quality deterioration" threshold value.

Therefore, when adjusting the branch distance L and machining speed V to satisfy τ > τ1 as described in the first embodiment described above, it is preferable to further adjust at least one of the machining speed V and the repetition frequency of the second laser light L2 so that the overlap rate does not exceed 50%. For example, if the repetition frequency of the second laser light L2 is 50 kHz and the overlap rate is 50%, the time threshold τ1 is τ1 = 20 µs, so that the branch distance L, etc. is adjusted to satisfy τ > 20 µs. This allows for a better machining quality of the hollow groove 19 than in the first embodiment.

### [Third Embodiment]

The laser machining apparatus 10 according to a third embodiment will now be described below. The laser machining apparatus 10 according to the third embodiment can adjust the spacing between the two edge cutting grooves 18 in the Y-direction and the width of the hollow groove 19 in the Y-direction. The laser machining apparatus 10 according to the third embodiment has basically the same configuration as the laser machining apparatus 10 according to the respective embodiments described above except that a first rotating mechanism 44 (see Figure 20) and a second rotating mechanism 46 (see Figure 21), described later, are provided. Therefore, those having the same function or configuration as the respective embodiments described above are designated by the same reference signs and description thereof will be omitted.

Figure 20 is an explanatory drawing for explaining adjustment of spacing between the two edge cutting grooves 18 in the Y-direction by the first rotating mechanism 44. As illustrated in Figure 20, the first rotating mechanism 44 (which corresponds to a first light forming element rotating mechanism of the presently disclosed subject matter) includes, for example, a motor and a drive transmission mechanism, and is configured to rotate the first light forming element 32 in a direction around the optical axis thereof under the control of the control device 30. Accordingly, when the wafer 12 is viewed from above in the Z-direction, spots SP1 of the two beams of first laser light L1 focused on the street C by the first condenser lens 38 can be rotated around the optical axis of the first condenser lens 38. Consequently, the spacing between the two edge cutting grooves 18 in the Y-direction can be adjusted by increasing or decreasing the spacing between two spots SP1 on the street C in the Y-direction.

Figure 21 is an explanatory drawing for explaining adjustment of width in the Y-direction of hollow groove 19 by the second rotating mechanism 46. Figure 22 is a top view of spots SP2 for each beam of branch light L2a according to a third embodiment.

As illustrated in Figure 21, the second rotating mechanism 46 (which corresponds to a second laser light rotating mechanism of the presently disclosed subject matter) includes, for example, a motor and a drive transmission mechanism in the same manner as the first rotating mechanism 44 and is configured to rotate the second light forming element 34 in a direction around the optical axis thereof under the control of the control device 30. Accordingly, as designated by reference characters XXIIA and XXIIB in Figure 22, when the wafer 12 is viewed from above in the Z-direction, spots SP2 for each of the beams of branch light L2a focused on the street C by the second condenser lenses 40A, 40B can be rotated around the optical axes of the second condenser lenses 40A, 40B.

Here, the spot SP2 for each of the beams of branch light L2a is rectangular, that is, non-circular. Therefore, by rotating each spot SP2, the width of the hollow groove 19 formed on the street C in the Y-direction can be adjusted, that is, can be increased or decreased. Note that the shape of each spot SP2 is not limited to the rectangular shape as long as it is non-circular shape.

The control device 30 drives the first rotating mechanism 44 and the second rotating mechanism 46 respectively based on an adjustment instruction input by the operator into an operating unit, not illustrated, to rotate the first light forming element 32 and the second light forming element 34 respectively, thereby adjusting the spacing between the two edge cutting grooves 18 and the width of the hollow groove 19.

### [Fourth Embodiment]

Figure 23 is a schematic drawing illustrating a laser optical system 24 of a laser machining apparatus 10 according to a fourth embodiment. The laser machining apparatus 10 of the respective embodiments described above generates the two beams of first laser light L1 for edge cutting based on the laser light LA emitted from the first laser light source 22A and a second laser light L2 for hollowing based on the laser light LB emitted from the second laser light source 22B. In contrast, the laser machining apparatus 10 according to the fourth embodiment generates the two beams of first laser light L1 and the second laser light L2 from laser light L0 emitted from a shared laser light source 22.

As illustrated in Figure 23, the laser machining apparatus 10 of the fourth embodiment includes basically the same configuration as the laser machining apparatus 10 of the respective embodiments described above, except that it has laser light source 22 instead of the first laser light source 22A and the second laser light source 22B and a safety shutter 100 and a branching element 31 instead of the first safety shutter 100A and the second safety shutter 100B. Therefore, those having the same function or configuration as the respective embodiments described above are designated by the same reference signs and description thereof will be omitted.

The laser light source 22 constitutes the branching element 31, the first light forming element 32, and the second light forming element 34 as well as the laser light emitting system of the presently disclosed subject matter. The laser light source 22 constantly emits laser light L0 (pulsed laser light, etc.) under the conditions (wavelength, pulse width, and repetition frequency, etc.) suitable for both edge cutting and hollowing. The laser light L0 emitted from the laser light source 22 enters the branching element 31 of the laser optical system 24.

The safety shutter 100 is provided as being freely insertable into and retractable from the optical path of the laser light L0 between the laser light source 22 and the branching element 31. The safety shutter drive mechanism 102 according to the fourth embodiment inserts and retracts the safety shutter 100 into and from an optical path of the laser light L0 under the control of the control device 30. The safety shutter drive mechanism 102 inserts the safety shutter 100 into the optical path described above except during laser machining. Likewise, the safety shutter drive mechanism 102 retracts the safety shutter 100 from the optical path described above during laser machining.

The branching element 31 (corresponding to the bifurcating element of the presently disclosed subject matter) may use, for example, a half mirror, or, in the same manner as the branching element 35, a diffractive optical element, a refractive optical element, a prism, and a combination thereof. The branching element 31 bifurcates the laser light L0 emitted from the laser light source 22 and lets one of the bifurcated laser lights L0 emit to the first light forming element 32 and lets the other laser light L0 emit to the second light forming element 34.

From then onward, focusing of two beams of first laser light L1 by the first light forming element 32 and formation of two beams of first laser light L1 on the street C by the first condenser lens 38 are performed in the same manner as each embodiment described above. In the same manner, the formation of the second laser light L2 by the second light forming element 34, the generation of each of the beams of branch light L2a by the branching element 35, the switching of the second condenser lenses 40A, 40B by the connection switching element 36, and the focusing of each of the beams of branch light L2a on the street C by the second condenser lenses 40A, 40B are performed.

### [Others]

In the respective embodiments described above of the laser machining apparatus 10, the spot SP1 focused on the street C by the first condenser lens 38, the respective spots SP2 focused on the street C by the second condenser lens 40A, and the respective spots SP2 focused on the street C by the second condenser lens 40B are mutually independent of each other. Therefore, if the positions of the first condenser lens 38 and the second condenser lenses 40A, 40B are fixed as in the respective embodiments described above, there will be a horizontal direction (Y-direction) and vertical direction (Z-direction) misalignment between the two edge cutting grooves 18 and the hollow groove 19, depending on the motion accuracy of the machining feed axis (X-axis) during laser machining.

The laser machining apparatus 10 according to the respective embodiments described above may be provided with a function for individually adjusting the positions of the spot SP1 focused on the street C by the first condenser lens 38, the respective spots SP2 focused on the street C by the second condenser lens 40A, and the respective spots SP2 focused on the street C by the second condenser lens 40B in the Y-direction and in the Z-direction. Accordingly, the positions of the respective spots SP1, SP2 in the Y-direction and the Z-direction can be adjusted (adjusted in parallelism) for example by the manufacturer of the laser machining apparatus 10.

Based on the images taken by the microscope 26 during the laser machining of the wafer 12, it is possible to trace the edge cutting spot SP1 with respect to the street C and each of the spots SP2 of the hollowing with respect to the center between the two edge cutting grooves 18. Furthermore, based on the above-mentioned taken images, the amount of displacement in the Z-direction (amount of displacement of the focusing position) of spot SP1 and each of the spots SP2 with respect to the surface of the wafer 12 (street C) can be adjusted.

In the respective embodiments described above, ON and OFF of the edge cutting and the hollowing are switched by inserting and retracting the respectively safety shutters 100, 100A, 100B into and from the optical path. However, ON and OFF of the edge cutting and the hollowing may be switched by turning the first laser light source 2 2A and second laser light source 22B (laser light source 22) ON and OFF. The first safety shutter 100A and the first high-speed shutter 47A may be integrated and the second safety shutter 100B and the second high-speed shutter 47B may be integrated.

In the respective embodiments described above, the edge cutting is performed by the first condenser lens 38 and the hollowing is performed by one of the second condenser lenses 40A, 40B for the street C. However, the edge cutting may be performed by one of the second condenser lenses 40A, 40B and the hollowing may be performed by the first condenser lens 38 for the street C. In this case as well, the connection switching element 36 is controlled so that the edge cutting always precedes the hollowing regardless of the machining feed direction.

In the respective embodiments described above, the second laser light L2 is branched into a plurality of beams of light within the second condenser lenses 40A, 40B, and the hollowing is performed in a state in which at least one of the branch distance L and the machining speed V (repetition frequency) is adjusted so that τ > τ1 is satisfied. However, the edge cutting may be performed in the same manner. In other words, the edge cutting may be performed with the two beams of first laser light L1 branched into a plurality of beams of light in the first condenser lens 38 and at least one of the branch distance L and the machining speed V may be adjusted so that τ > τ1 is satisfied.

In the respective embodiments described above, laser machining is performed using the first condenser lens 38 and the second condenser lenses 40A, 40B, but laser machining may be performed using two types of condenser lenses (corresponding to the first and second condenser lenses of the presently disclosed subject matter). In this case, depending on the direction of relative movement of the laser optical system 24 relative to the wafer 12, the edge cutting by one of the two types of condenser lenses and the hollowing by the other, and the edge cutting by the other of the two types of condenser lenses and the hollowing by one of the two types of condenser lenses are switched.

In the respective embodiments described above, laser machining of two streets C (forward path and returning path) is performed by moving the laser optical system 24 back and forth once in the X-direction relative to the wafer 12. However, the presently disclosed subject matter can also be applied to the laser machining apparatus 10 in which the laser machining direction is fixed in one direction.

### {Reference Signs List}

- 10: laser machining apparatus
- 12: wafer
- 14: chip
- 16: device
- 18: edge cutting groove
- 19: hollow groove
- 20: table
- 22: laser light source
- 22A: first laser light source
- 22B: second laser light source
- 24: laser optical system
- 26: microscope
- 28: relative movement mechanism
- 30: control device
- 31, 35: branching element
- 32: first light forming element
- 34: second light forming element
- 36: connection switching element
- 38: first condenser lens
- 40A, 40B: second condenser lens
- 44: first rotating mechanism
- 46: second rotating mechanism
- 47A: first high-speed shutter
- 47B: second high-speed shutter
- 47C: high-speed shutter drive mechanism
- 100: safety shutter
- 100A: first safety shutter
- 100B: second safety shutter
- 102: safety shutter drive mechanism
- HS: heat storage
- L: branch distance
- L0: laser light
- L1: first laser light
- L2: second laser light
- L2a: branched light
- LA, LB: laser light
- OA: region
- SP1, SP2: spot
- SP2a: leading spot
- SP2b: trailing spot
- V: machining speed
- X1: forward path direction side
- X2: returning path direction side
- d: spot displacement
- τ1: time threshold value

## Claims

1. A laser machining apparatus (10)
comprising a table (20), a laser light source (22A, 22B, 22), a laser optical system (24), a microscope (26), a relative movement mechanism (28), and a control device (30), and
configured to perform edge cutting for forming two first grooves parallel to each other along a street, and configured to perform hollowing for forming a second groove between the two first grooves with the laser optical system (24) while moving the laser optical system relative to the table that is configured to hold a wafer in a machining feed direction along the street of the wafer,
the laser optical system (24) including:
a laser light emitting system (22, 22A, 22B, 31, 32, 34) configured to emit two beams of first laser light for the edge cutting and a second laser light for the hollowing;
a first condenser lens (38) configured to focus the two beams of first laser light emitted from the laser light emitting system onto the street to be machined;
a branching element (35) configured to branch the second laser light emitted from the laser light emitting system into a plurality of beams of branch light along the machining feed direction, and
a second condenser lens (40A, 40B) configured to focus the plurality of beams of the branch light branched by the branching element onto the street to be machined,
wherein the control device (30) is configured to control the operation of the laser light source (22A, 22B, 22), the laser optical system (24), the microscope (26), and the relative movement mechanism (28) to perform the hollowing with at least one of the branch distance L and the machining speed V adjusted to satisfy τ > τ1, and
wherein a time period τ is expressed as τ = L/V, where L is a branch distance, which corresponds to spacing between adjacent leading and trailing spots for each beam of the branch light focused on the street by the second condenser lens, V is a machining speed, which corresponds to a speed of the relative movement of the laser optical system (24), and τ is the time period taken until the trailing spot overlaps a machining position of the leading spot, and where τ1 is a threshold value of the time period at which deterioration of machining quality of the second groove occurs.

2. The laser machining apparatus (10) according to claim 1, wherein the laser light emitting system (22A, 22B, 32, 34) comprises:
a first laser light source (22A) configured to emit laser light under a condition corresponding to the edge cutting;
a second laser light source (22B) configured to emit laser light under a condition corresponding to the hollowing;
a first light forming element (32) configured to form the two beams of first laser light from the laser light emitted from the first laser light source; and
a second light forming element (34) configured to form the second laser light from the laser light emitted from the second laser light source, and
wherein the branching element (35) is provided on an optical path between the second light forming element and the second condenser lens.

3. The laser machining apparatus (10) according to claim 1, wherein the laser light emitting system (22, 31, 32, 34) comprises:
the laser light source (22) configured to emit laser light,
a bifurcating element (31) configured to bifurcate the laser light emitted from the laser light source;
a first light forming element (32) configured to form the two beams of first laser light from one of the laser lights bifurcated by the bifurcating element; and
a second light forming element (34) configured to form the second laser lights from the other one of the laser lights bifurcated by the bifurcating element,
wherein the branching element (35) is provided on the optical path between the second light forming element and the second condenser lens.

4. The laser machining apparatus (10) according to claim 2 or 3, wherein the second light forming element (34) forms the second laser light that forms the spot of a non-circular shape on the street, and
the laser machining apparatus (10) further comprises a second light forming element rotating mechanism (46) configured to rotate the second light forming element (34) in a direction around an axis centered on an optical axis of the second light forming element.

5. The laser machining apparatus (10) according to any one of claims 2 to 4, comprising a first light forming element rotating mechanism (44) configured to rotate the first light forming element (32) in a direction around an optical axis of the first light forming element.

6. The laser machining apparatus (10) according to any one of claims 1 to 5, wherein the second condenser lens (40A, 40B) includes two lenses that are arranged with the first condenser lens interposed therebetween and are arranged in a row along the machining feed direction together with the first condenser lens, and
the laser machining apparatus further comprises a connecting optical system configured to guide the two beams of first laser light emitted from the laser light emitting system to the first condenser lens and selectively guide a plurality of beams of the branch light branched by a branching element to the two lenses of the second condenser lens,
wherein the connecting optical system is configured to guide a plurality of beams of the branch light to the second condenser lens positioned on a returning path direction side with respect to the first condenser lens, which is opposite from a forward path direction side, when the control device (30) controls the operation of the relative movement mechanism (28) such that the laser optical system is moved toward the forward path direction side of the machining feed direction relative to the table, and is configured to guide a plurality of beams of the beams of branch light to the second condenser lens positioned on the forward path direction side with respect to the first condenser lens when the control device (30) controls the operation of the relative movement mechanism (28) such that the laser optical system is moved toward the retuming path direction side relative to the table.

7. The laser machining apparatus (10) according to any one of claims 1 to 6, wherein the second laser light is a pulsed laser light, and
the control device (30) is configured to control the operation of the laser light source (22A, 22B, 22), the laser optical system (24), the microscope (26), and the relative movement mechanism (28) to perform the hollowing with at least one of the machining speed and a repetition frequency of the second laser light adjusted to make an overlap rate in the machining feed direction of a next spot to be irradiated to the spot be 50% or less.

8. A laser machining method for performing edge cutting for forming two first grooves parallel to each other along a street, and hollowing for forming a second groove between the two first grooves with a laser optical system (24) while moving the laser optical system relative to a table that holds a wafer in a machining feed direction along the street of the wafer,
wherein the laser optical system (24) performs:
emitting two beams of first laser light for the edge cutting and a second laser light for the hollowing;
focusing the two beams of first laser light onto the street to be machined by the first condenser lens (38);
branching the second laser light into a plurality of beams of branch light along the machining feed direction, and
focusing the plurality of beams of the branch light onto the street to be machined by the second condenser lens (40A, 40B),
wherein a time period τ is expressed as τ = L/V, where L is a branch distance, which corresponds to spacing between adjacent leading and trailing spots for each beam of the branch light focused on the street by the second condenser lens (40A, 40B), V is a machining speed, which corresponds to a speed of the relative movement of the laser optical system (24), and τ is the time period taken until the trailing spot overlaps the machining position of the leading spot, and
wherein the method further comprises adjusting at least one of the branch distance L and the machining speed V to satisfy τ > τ1, where τ1 is a threshold value of the time period at which deterioration of the machining quality of the second groove occurs.

## Patentansprüche

1. Laserbearbeitungsvorrichtung (10),
umfassend einen Tisch (20), eine Laserlichtquelle (22A, 22B, 22), ein Laseroptiksystem (24), ein Mikroskop (26), einen Relativbewegungsmechanismus (28) und eine Steuervorrichtung (30), und
dazu eingerichtet, ein Randschneiden zum Ausbilden von zwei zueinander parallelen ersten Nuten entlang einer Trennlinie durchzuführen, und dazu eingerichtet, eine Ausnutung zum Ausbilden einer zweiten Nut zwischen den zwei ersten Nuten mit dem Laseroptiksystem (24) durchzuführen, während das Laseroptiksystem relativ zu dem Tisch, der dazu eingerichtet ist, einen Wafer zu halten, in einer Bearbeitungsvorschubrichtung entlang der Trennlinie des Wafers bewegt wird,
wobei das Laseroptiksystem (24) umfasst:
ein Laserlichtemissionssystem (22, 22A, 22B, 31, 32, 34), das dazu eingerichtet ist, zwei Strahlen eines ersten Laserlichts für das Randschneiden und ein zweites Laserlicht für die Ausnutung zu emittieren;
eine erste Kondensorlinse (38), die dazu eingerichtet ist, die zwei Strahlen des ersten Laserlichts, die von dem Laserlichtemissionssystem emittiert werden, auf die zu bearbeitende Trennlinie zu fokussieren;
ein Verzweigungselement (35), das dazu eingerichtet ist, das von dem Laserlichtemissionssystem emittierte zweite Laserlicht in eine Vielzahl von Zweiglichtstrahlen entlang der Bearbeitungsvorschubrichtung zu verzweigen, und
eine zweite Kondensorlinse (40A, 40B), die dazu eingerichtet ist, die Vielzahl von Zweiglichtstrahlen, die durch das Verzweigungselement verzweigt werden, auf die zu bearbeitende Trennlinie zu fokussieren,
wobei die Steuervorrichtung (30) dazu eingerichtet ist, den Betrieb der Laserlichtquelle (22A, 22B, 22), des Laseroptiksystems (24), des Mikroskops (26) und des Relativbewegungsmechanismus (28) zu steuern, um die Ausnutung durchzuführen, wobei wenigstens einer von dem Verzweigungsabstand L und der Bearbeitungsgeschwindigkeit V so eingestellt wird, dass τ > τ1 erfüllt ist, und
wobei eine Zeitdauer τ als τ = L/V ausgedrückt wird, wobei L ein Verzweigungsabstand ist, der einem Abstand zwischen benachbarten vorlaufenden und nachlaufenden Lichtflecken für jeden Strahl des Zweiglichts entspricht, der durch die zweite Kondensorlinse auf die Trennlinie fokussiert wird, V eine Bearbeitungsgeschwindigkeit ist, die einer Geschwindigkeit der Relativbewegung des Laseroptiksystems (24) entspricht, und τ die Zeitdauer ist, die vergeht, bis der nachlaufende Lichtfleck eine Bearbeitungsposition des vorlaufenden Lichtflecks überlappt, und wobei τ1 ein Schwellenwert der Zeitdauer ist, bei dem eine Verschlechterung der Bearbeitungsqualität der zweiten Nut auftritt.

2. Laserbearbeitungsvorrichtung (10) nach Anspruch 1, wobei das Laserlichtemissionssystem (22A, 22B, 32, 34) umfasst:
eine erste Laserlichtquelle (22A), die dazu eingerichtet ist, Laserlicht unter einer Bedingung zu emittieren, die dem Randschneiden entspricht;
eine zweite Laserlichtquelle (22B), die dazu eingerichtet ist, Laserlicht unter einer Bedingung zu emittieren, die der Ausnutung entspricht;
ein erstes Lichtformungselement (32), das dazu eingerichtet ist, die zwei Strahlen des ersten Laserlichts aus dem von der ersten Laserlichtquelle emittierten Laserlicht auszubilden; und
ein zweites Lichtformungselement (34), das dazu eingerichtet ist, das zweite Laserlicht aus dem von der zweiten Laserlichtquelle emittierten Laserlicht auszubilden, und
wobei das Verzweigungselement (35) auf einem optischen Pfad zwischen dem zweiten Lichtformungselement und der zweiten Kondensorlinse vorgesehen ist.

3. Laserbearbeitungsvorrichtung (10) nach Anspruch 1, wobei das Laserlichtemissionssystem (22, 31, 32, 34) umfasst:
die Laserlichtquelle (22), die dazu eingerichtet ist, Laserlicht zu emittieren,
ein Aufteilungselement (31), das dazu eingerichtet ist, das von der Laserlichtquelle emittierte Laserlicht aufzuteilen;
ein erstes Lichtformungselement (32), das dazu eingerichtet ist, die zwei Strahlen des ersten Laserlichts aus einem der durch das Aufteilungselement aufgeteilten Laserlichter auszubilden; und
ein zweites Lichtformungselement (34), das dazu eingerichtet ist, die zweiten Laserlichter aus dem anderen der durch das Aufteilungselement aufgeteilten Laserlichter auszubilden,
wobei das Verzweigungselement (35) auf dem optischen Pfad zwischen dem zweiten Lichtformungselement und der zweiten Kondensorlinse vorgesehen ist.

4. Laserbearbeitungsvorrichtung (10) nach Anspruch 2 oder 3, wobei das zweite Lichtformungselement (34) das zweite Laserlicht ausbildet, das den Lichtfleck einer nichtkreisförmigen Form auf der Trennlinie ausbildet, und
die Laserbearbeitungsvorrichtung (10) ferner einen zweiten Lichtformungselement-Drehmechanismus (46) umfasst, der dazu eingerichtet ist, das zweite Lichtformungselement (34) in einer Richtung um eine Achse zu drehen, die auf einer optischen Achse des zweiten Lichtformungselements zentriert ist.

5. Laserbearbeitungsvorrichtung (10) nach einem der Ansprüche 2 bis 4, umfassend einen ersten Lichtformungselement-Drehmechanismus (44), der dazu eingerichtet ist, das erste Lichtformungselement (32) in einer Richtung um eine optische Achse des ersten Lichtformungselements zu drehen.

6. Laserbearbeitungsvorrichtung (10) nach einem der Ansprüche 1 bis 5, wobei die zweite Kondensorlinse (40A, 40B) zwei Linsen umfasst, die so angeordnet sind, dass die erste Kondensorlinse zwischen ihnen angeordnet ist, und die zusammen mit der ersten Kondensorlinse in einer Reihe entlang der Bearbeitungsvorschubrichtung angeordnet sind, und
die Laserbearbeitungsvorrichtung ferner ein Verbindungsoptiksystem umfasst, das dazu eingerichtet ist, die zwei Strahlen des ersten Laserlichts, die von dem Laserlichtemissionssystem emittiert werden, zu der ersten Kondensorlinse zu führen und eine Vielzahl von Strahlen des Zweiglichts, die durch ein Verzweigungselement verzweigt werden, selektiv zu den zwei Linsen der zweiten Kondensorlinse zu führen,
wobei das Verbindungsoptiksystem dazu eingerichtet ist, eine Vielzahl von Strahlen des Zweiglichts zu der zweiten Kondensorlinse zu führen, die auf einer Rücklaufweg-Richtungsseite in Bezug auf die erste Kondensorlinse angeordnet ist, die einer Vorlaufweg-Richtungsseite entgegengesetzt ist, wenn die Steuervorrichtung (30) den Betrieb des Relativbewegungsmechanismus (28) so steuert, dass das Laseroptiksystem relativ zu dem Tisch zu der Vorlaufweg-Richtungsseite der Bearbeitungsvorschubrichtung bewegt wird, und dazu eingerichtet ist, eine Vielzahl von Strahlen der Strahlen des Zweiglichts zu der zweiten Kondensorlinse zu führen, die auf der Vorlaufweg-Richtungsseite in Bezug auf die erste Kondensorlinse angeordnet ist, wenn die Steuervorrichtung (30) den Betrieb des Relativbewegungsmechanismus (28) so steuert, dass das Laseroptiksystem relativ zu dem Tisch zu der Rücklaufweg-Richtungsseite bewegt wird.

7. Laserbearbeitungsvorrichtung (10) nach einem der Ansprüche 1 bis 6, wobei das zweite Laserlicht ein gepulstes Laserlicht ist, und
die Steuervorrichtung (30) dazu eingerichtet ist, den Betrieb der Laserlichtquelle (22A, 22B, 22), des Laseroptiksystems (24), des Mikroskops (26) und des Relativbewegungsmechanismus (28) zu steuern, um die Ausnutung durchzuführen, wobei wenigstens eine von der Bearbeitungsgeschwindigkeit und einer Wiederholfrequenz des zweiten Laserlichts so eingestellt wird, dass ein Überlappungsgrad in der Bearbeitungsvorschubrichtung eines nächsten auf den Lichtfleck zu bestrahlenden Lichtflecks 50 % oder weniger beträgt.

8. Laserbearbeitungsverfahren zum Durchführen eines Randschneidens zum Ausbilden von zwei zueinander parallelen ersten Nuten entlang einer Trennlinie und einer Ausnutung zum Ausbilden einer zweiten Nut zwischen den zwei ersten Nuten mit einem Laseroptiksystem (24), während das Laseroptiksystem relativ zu einem Tisch, der einen Wafer hält, in einer Bearbeitungsvorschubrichtung entlang der Trennlinie des Wafers bewegt wird,
wobei das Laseroptiksystem (24) durchführt:
Emittieren von zwei Strahlen eines ersten Laserlichts für das Randschneiden und eines zweiten Laserlichts für die Ausnutung;
Fokussieren der zwei Strahlen des ersten Laserlichts auf die zu bearbeitende Trennlinie durch die erste Kondensorlinse (38);
Verzweigen des zweiten Laserlichts in eine Vielzahl von Zweiglichtstrahlen entlang der Bearbeitungsvorschubrichtung, und
Fokussieren der Vielzahl von Zweiglichtstrahlen auf die zu bearbeitende Trennlinie durch die zweite Kondensorlinse (40A, 40B),
wobei eine Zeitdauer τ als τ = L/V ausgedrückt wird, wobei L ein Verzweigungsabstand ist, der einem Abstand zwischen benachbarten vorlaufenden und nachlaufenden Lichtflecken für jeden Strahl des Zweiglichts entspricht, der durch die zweite Kondensorlinse (40A, 40B) auf die Trennlinie fokussiert wird, V eine Bearbeitungsgeschwindigkeit ist, die einer Geschwindigkeit der Relativbewegung des Laseroptiksystems (24) entspricht, und τ die Zeitdauer ist, die vergeht, bis der nachlaufende Lichtfleck die Bearbeitungsposition des vorlaufenden Lichtflecks überlappt, und
wobei das Verfahren ferner das Einstellen wenigstens eines von dem Verzweigungsabstand L und der Bearbeitungsgeschwindigkeit V umfasst, um τ > τ1 zu erfüllen, wobei τ1 ein Schwellenwert der Zeitdauer ist, bei dem eine Verschlechterung der Bearbeitungsqualität der zweiten Nut auftritt.

## Revendications

1. Dispositif d'usinage laser (10)
comprenant une table (20), une source de lumière laser (22A, 22B, 22), un système optique laser (24), un microscope (26), un mécanisme de déplacement relatif (28) et un dispositif de commande (30), et
configuré pour effectuer une découpe des bords afin de former deux premières rainures parallèles l'une à l'autre le long d'une ligne de découpe, et configuré pour effectuer un évidement afin de former une seconde rainure entre les deux premières rainures avec le système optique laser (24) tout en déplaçant le système optique laser par rapport à la table qui est configurée pour maintenir une tranche dans une direction d'avance d'usinage le long de la ligne de découpe de la tranche,
le système optique laser (24) comprenant :
un système d'émission de lumière laser (22, 22A, 22B, 31, 32, 34) configuré pour émettre deux faisceaux d'une première lumière laser pour la découpe des bords et une seconde lumière laser pour l'évidement ;
une première lentille de condensation (38) configurée pour focaliser les deux faisceaux de première lumière laser émis par le système d'émission de lumière laser sur la ligne de découpe à usiner ;
un élément de ramification (35) configuré pour ramifier la seconde lumière laser émise par le système d'émission de lumière laser en une pluralité de faisceaux de lumière de branchement le long de la direction d'avance d'usinage, et
une seconde lentille de condensation (40A, 40B) configurée pour focaliser la pluralité de faisceaux de lumière de branchement ramifiés par l'élément de ramification sur la ligne de découpe à usiner,
dans lequel le dispositif de commande (30) est configuré pour commander le fonctionnement de la source de lumière laser (22A, 22B, 22), du système optique laser (24), du microscope (26) et du mécanisme de déplacement relatif (28) afin d'effectuer l'évidement avec au moins l'une de la distance de ramification L et de la vitesse d'usinage V ajustée pour satisfaire à τ > τ1, et
dans lequel une durée τ est exprimée par τ = L/V, où L est une distance de ramification qui correspond à un espacement entre des taches lumineuses avant et arrière adjacentes pour chaque faisceau de lumière de branchement focalisé sur la ligne de découpe par la seconde lentille de condensation, V est une vitesse d'usinage qui correspond à une vitesse du déplacement relatif du système optique laser (24), et τ est la durée nécessaire jusqu'à ce que la tache lumineuse arrière chevauche une position d'usinage de la tache lumineuse avant, et où τ1 est une valeur seuil de la durée à laquelle une détérioration de la qualité d'usinage de la seconde rainure se produit.

2. Dispositif d'usinage laser (10) selon la revendication 1, dans lequel le système d'émission de lumière laser (22A, 22B, 32, 34) comprend :
une première source de lumière laser (22A) configurée pour émettre une lumière laser dans une condition correspondant à la découpe des bords ;
une seconde source de lumière laser (22B) configurée pour émettre une lumière laser dans une condition correspondant à l'évidement ;
un premier élément de mise en forme de lumière (32) configuré pour former les deux faisceaux de première lumière laser à partir de la lumière laser émise par la première source de lumière laser ; et
un second élément de mise en forme de lumière (34) configuré pour former la seconde lumière laser à partir de la lumière laser émise par la seconde source de lumière laser, et
dans lequel l'élément de ramification (35) est disposé sur un trajet optique entre le second élément de mise en forme de lumière et la seconde lentille de condensation.

3. Dispositif d'usinage laser (10) selon la revendication 1, dans lequel le système d'émission de lumière laser (22, 31, 32, 34) comprend :
la source de lumière laser (22) configurée pour émettre une lumière laser,
un élément de division (31) configuré pour diviser la lumière laser émise par la source de lumière laser ;
un premier élément de mise en forme de lumière (32) configuré pour former les deux faisceaux de première lumière laser à partir de l'une des lumières laser divisées par l'élément de division ; et
un second élément de mise en forme de lumière (34) configuré pour former les secondes lumières laser à partir de l'autre des lumières laser divisées par l'élément de division,
dans lequel l'élément de ramification (35) est disposé sur le trajet optique entre le second élément de mise en forme de lumière et la seconde lentille de condensation.

4. Dispositif d'usinage laser (10) selon la revendication 2 ou 3, dans lequel le second élément de mise en forme de lumière (34) forme la seconde lumière laser qui forme la tache lumineuse d'une forme non circulaire sur la ligne de découpe, et
le dispositif d'usinage laser (10) comprend en outre un second mécanisme de rotation d'élément de mise en forme de lumière (46) configuré pour faire tourner le second élément de mise en forme de lumière (34) dans une direction autour d'un axe centré sur un axe optique du second élément de mise en forme de lumière.

5. Dispositif d'usinage laser (10) selon l'une quelconque des revendications 2 à 4, comprenant un premier mécanisme de rotation d'élément de mise en forme de lumière (44) configuré pour faire tourner le premier élément de mise en forme de lumière (32) dans une direction autour d'un axe optique du premier élément de mise en forme de lumière.

6. Dispositif d'usinage laser (10) selon l'une quelconque des revendications 1 à 5, dans lequel la seconde lentille de condensation (40A, 40B) comprend deux lentilles qui sont agencées avec la première lentille de condensation interposée entre elles et sont agencées en rangée le long de la direction d'avance d'usinage conjointement avec la première lentille de condensation, et
le dispositif d'usinage laser comprend en outre un système optique de connexion configuré pour guider les deux faisceaux de première lumière laser émis par le système d'émission de lumière laser vers la première lentille de condensation et pour guider sélectivement une pluralité de faisceaux de lumière de branchement ramifiés par un élément de ramification vers les deux lentilles de la seconde lentille de condensation,
dans lequel le système optique de connexion est configuré pour guider une pluralité de faisceaux de lumière de branchement vers la seconde lentille de condensation positionnée d'un côté de la direction du trajet retour par rapport à la première lentille de condensation, qui est opposé à un côté de la direction du trajet aller, lorsque le dispositif de commande (30) commande le fonctionnement du mécanisme de déplacement relatif (28) de telle sorte que le système optique laser soit déplacé vers le côté de la direction du trajet aller de la direction d'avance d'usinage par rapport à la table, et est configuré pour guider une pluralité de faisceaux des faisceaux de lumière de branchement vers la seconde lentille de condensation positionnée du côté de la direction du trajet aller par rapport à la première lentille de condensation lorsque le dispositif de commande (30) commande le fonctionnement du mécanisme de déplacement relatif (28) de telle sorte que le système optique laser soit déplacé vers le côté de la direction du trajet retour par rapport à la table.

7. Dispositif d'usinage laser (10) selon l'une quelconque des revendications 1 à 6, dans lequel la seconde lumière laser est une lumière laser pulsée, et
le dispositif de commande (30) est configuré pour commander le fonctionnement de la source de lumière laser (22A, 22B, 22), du système optique laser (24), du microscope (26) et du mécanisme de déplacement relatif (28) afin d'effectuer l'évidement avec au moins l'une de la vitesse d'usinage et d'une fréquence de répétition de la seconde lumière laser ajustée de manière à ce qu'un taux de chevauchement dans la direction d'avance d'usinage d'une prochaine tache lumineuse à irradier sur la tache lumineuse soit de 50 % ou moins.

8. Procédé d'usinage laser pour effectuer une découpe des bords afin de former deux premières rainures parallèles l'une à l'autre le long d'une ligne de découpe, et un évidement afin de former une seconde rainure entre les deux premières rainures avec un système optique laser (24) tout en déplaçant le système optique laser par rapport à une table qui maintient une tranche dans une direction d'avance d'usinage le long de la ligne de découpe de la tranche,
dans lequel le système optique laser (24) effectue :
l'émission de deux faisceaux d'une première lumière laser pour la découpe des bords et d'une seconde lumière laser pour l'évidement ;
la focalisation des deux faisceaux de première lumière laser sur la ligne de découpe à usiner par la première lentille de condensation (38) ;
la ramification de la seconde lumière laser en une pluralité de faisceaux de lumière de branchement le long de la direction d'avance d'usinage, et
la focalisation de la pluralité de faisceaux de lumière de branchement sur la ligne de découpe à usiner par la seconde lentille de condensation (40A, 40B),
dans lequel une durée τ est exprimée par τ = L/V, où L est une distance de ramification qui correspond à un espacement entre des taches lumineuses avant et arrière adjacentes pour chaque faisceau de lumière de branchement focalisé sur la ligne de découpe par la seconde lentille de condensation (40A, 40B), V est une vitesse d'usinage qui correspond à une vitesse du déplacement relatif du système optique laser (24), et τ est la durée nécessaire jusqu'à ce que la tache lumineuse arrière chevauche la position d'usinage de la tache lumineuse avant, et
dans lequel le procédé comprend en outre l'ajustement d'au moins l'une de la distance de ramification L et de la vitesse d'usinage V pour satisfaire à τ > τ1, où τ1 est une valeur seuil de la durée à laquelle une détérioration de la qualité d'usinage de la seconde rainure se produit.
